# EUROPEAN PATENT APPLICATION

(11) **EP 4 641 058 A1**
(43) Date of publication of application: **29.10.2025**
(21) Application number: 25170474.8
(22) Date of filing: 14.04.2025
(51) Int. Cl.: F16K 11/085, B60K 11/02, F16K 27/06

(54) **COOLING MODULE**

(30) Priority: 25.04.2024 JP 2024071792
(71) Applicant: Aisin Corporation, Kariya, Aichi 448-8650 (JP)
(72) Inventor: TANAKA, Hirokazu, Kariya, 448-8650 (JP); ISHII, Masato, Kariya, 448-8650 (JP); YUMISASHI, Naoto, Kariya, 448-8650 (JP); YOSHIDA, Masazumi, Kariya, 448-8650 (JP)
(74) Representative: Winter, Brandl - Partnerschaft mbB

(57) **Abstract**

The cooling module (1) includes: a manifold (60) being made of resin and including a plurality of housings joined to one another; and a rotary valve (10) formed by arranging a valve body (12) rotating about a rotation axis (X) in a cylindrical valve chamber (30) formed in the manifold (60). The manifold (60) includes a plurality of internal flow paths (68a, 68b, 68c, 68d, 68e) through which fluid flows and a plurality of ports (64a, 64b, 64e, 64g, 64h) that are connected to a plurality of the internal flow paths (68a, 68b, 68c, 68d, 68e) and through which the fluid flows in or flows out. The rotary valve (10) has a full communication mode in which, when the fluid is flowed in from one port (64a) of a plurality of the ports, the fluid can be flowed out from all the other ports (64b, 64e, 64g, 64h).

## Description

### TECHNICAL FIELD

The present disclosure generally relates to a cooling module.

### BACKGROUND DISCUSSION

In recent years, vehicles including a motor as a traveling drive source (a hybrid electric vehicle (HEV), a plug-in hybrid electric vehicle (PHEV), a battery electric vehicle (BEV), a fuel cell electric vehicle (FCEV), or the like) have been widely accepted. Such vehicles include a battery for driving the motor. Since such vehicles include a lot of devices that need to be cooled, such as a motor (including an internal-combustion mechanism like an engine), a battery, an air conditioner, and an ECU, the devices are cooled by forming a cooling circuit through which cooling water is circulated. However, there are some cases where each of such devices has a different proper operating temperature. In such a case, since temperature of cooling water to be circulated is changed for each of the devices operating temperatures of which are different from one another, an independent cooling circuit needs to be formed with respect to each temperature of cooling water and routing of pipes of the cooling circuit and a circuit configuration become complex. A valve that switches flow paths is also required to cope with such a complex circuit configuration.

In JP2017-150352A (Reference 1), a cooling module (in Reference 1, a thermal management device for vehicle) including a reserve tank being common to a plurality of cooling water circuits is disclosed. In the cooling module, the reserve tank can be connected to all of the plurality of cooling water circuits and cooling water can be flowed through the cooling water circuits when the vehicle is started, when the vehicle is in a maintenance mode, and when the vehicle is stopped while air conditioning is stopped. Specifically, each of a plurality of cooling water flow paths has an open-close valve, and by controlling a plurality of the open-close valves, cooling water can be flowed through all of the plurality of cooling water circuits. By connecting the common reserve tank to all of the plurality of cooling water circuits, air bleeding of cooling water can be performed in the reserve tank.

Since, in the cooling module disclosed in Reference 1, a plurality of open-close valves need to be controlled in order to flow cooling water through all of the plurality of cooling water circuits and a system thus becomes complex, there is room for improvement. In addition, in order to perform air bleeding in the reserve tank, a dedicated air bleeding valve is further required, and, as a result, a large number of valves are required, which leads to an increase in cost of the cooling module, and there is room for improvement.

A need thus exists for a cooling module that can flow fluid through all of a plurality of flow paths with a small number of valves.

### SUMMARY

One embodiment of a cooling module according to the present disclosure includes: a manifold being made of resin and including a plurality of housings joined to one another; and a rotary valve formed by arranging a valve body rotating about a rotation axis in a cylindrical valve chamber formed in the manifold, wherein the manifold includes a plurality of internal flow paths through which fluid flows and a plurality of ports that are connected to a plurality of the internal flow paths and through which the fluid flows in or flows out, and the rotary valve has a full communication mode in which, when the fluid is flowed in from one of a plurality of the ports, the fluid can be flowed out from all the other ports.

According to the present embodiment, since the rotary valve has the full communication mode in which, when fluid is flowed in from one of a plurality of the ports, the fluid can be flowed out from all the other ports, cooling water can be flowed through all flow paths in the cooling module without using a dedicated valve for air bleeding or controlling opening and closing of a plurality of valves. Because of this configuration, a cooling module that can flow fluid through all of a plurality of flow paths with a small number of valves can be provided.

### BRIEF DESCRIPTION OF THE DRAWINGS

The foregoing and additional features and characteristics of this disclosure will become more apparent from the following detailed description considered with the reference to the accompanying drawings, wherein:
Fig. 1 is a perspective view of a cooling module;
Fig. 2 is a perspective view of a valve body of a rotary valve;
Fig. 3 is a lateral cross-sectional view illustrating flow-through holes in an upper layer of the valve body;
Fig. 4 is a lateral cross-sectional view illustrating flow-through holes in a lower layer of the valve body;
Fig. 5 is a cross-sectional view illustrating flows of cooling water in the lower layer in a first mode;
Fig. 6 is an enlarged view of the rotary valve in Fig. 5;
Fig. 7 is a cross-sectional view illustrating flows of cooling water in the upper layer in the first mode;
Fig. 8 is an enlarged view of the rotary valve in Fig. 7;
Fig. 9 is a cross-sectional view illustrating flows of cooling water in the lower layer in a second mode;
Fig. 10 is an enlarged view of the rotary valve in Fig. 9;
Fig. 11 is a cross-sectional view illustrating flows of cooling water in the upper layer in the second mode;
Fig. 12 is an enlarged view of the rotary valve in Fig. 11;
Fig. 13 is a cross-sectional view illustrating flows of cooling water in the lower layer in a third mode;
Fig. 14 is an enlarged view of the rotary valve in Fig. 13;
Fig. 15 is a cross-sectional view illustrating flows of cooling water in the upper layer in the third mode;
Fig. 16 is an enlarged view of the rotary valve in Fig. 15;
Fig. 17 is a cross-sectional view illustrating flows of cooling water in the lower layer in a fourth mode;
Fig. 18 is an enlarged view of the rotary valve in Fig. 17;
Fig. 19 is a cross-sectional view illustrating flows of cooling water in the upper layer in the fourth mode;
Fig. 20 is an enlarged view of the rotary valve in Fig. 19;
Fig. 21 is a cross-sectional view illustrating flows of cooling water in the lower layer in a fifth mode;
Fig. 22 is an enlarged view of the rotary valve in Fig. 21;
Fig. 23 is a cross-sectional view illustrating flows of cooling water in the upper layer in the fifth mode;
Fig. 24 is an enlarged view of the rotary valve in Fig. 23;
Fig. 25 is a cross-sectional view illustrating flows of cooling water in the lower layer in a sixth mode;
Fig. 26 is an enlarged view of the rotary valve in Fig. 25;
Fig. 27 is a cross-sectional view illustrating flows of cooling water in the upper layer in the sixth mode;
Fig. 28 is an enlarged view of the rotary valve in Fig. 27;
Fig. 29 is a cross-sectional view illustrating flows of cooling water in the lower layer in a full communication mode;
Fig. 30 is an enlarged view of the rotary valve in Fig. 29;
Fig. 31 is a cross-sectional view illustrating flows of cooling water in the upper layer in the full communication mode; and
Fig. 32 is an enlarged view of the rotary valve in Fig. 31.

### DETAILED DESCRIPTION

An embodiment of a cooling module according to the present disclosure will be described below in detail, based on the drawings. Note that the embodiment described below is an example for describing the cooling module and is not intended to limit the cooling module only to the embodiment. Therefore, the cooling module according to the present disclosure can be embodied in various modes without departing from the scope of the present disclosure.

### [Configuration of Cooling Module]

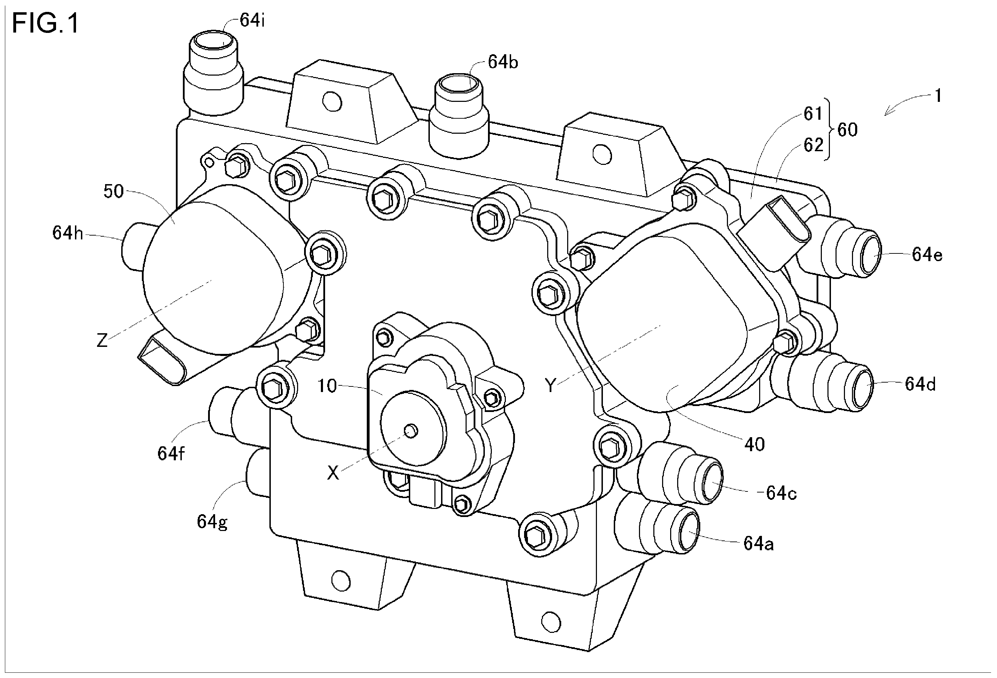

A cooling module 1 according to the present embodiment is used in a vehicle including a motor as a traveling drive source, such as s hybrid electric vehicle (HEV), a plug-in hybrid electric vehicle (PHEV), a battery electric vehicle (BEV), and a fuel cell electric vehicle (FCEV) (hereinafter, collectively referred to as "electric vehicle"). The cooling module 1 include, as illustrated in Fig. 1, nine ports including a first port 64a (an example of a port), a second port 64b (another example of the port), a third port 64c (still another example of the port), a fourth port 64d (still another example of the port), a fifth port 64e (still another example of the port), a sixth port 64f (still another example of the port), a seventh port 64g (still another example of the port), an eighth port 64h (still another example of the port), and a ninth port 64i (still another example of the port). A pipe (not illustrated) through which cooling water (an example of fluid) flows is connected to each of the nine ports, and an auxiliary machine (not illustrated), such as a wheel drive device and a heat exchanger, is arranged at the middle of the pipe. The cooling module 1 controls temperature of each auxiliary machine by controlling flow of cooling water through control of a corresponding port (pipe) through which cooling water is to be flowed.

As illustrated in Figs. 1 to 4, the cooling module 1 includes a rotary valve 10, a first water pump 40, a second water pump 50, and a manifold 60 in which a plurality of flow paths through which cooling water is flowed to the foregoing are formed. The manifold 60 of the present embodiment is formed by joining a plurality of (in the present embodiment, two) housings made of resin. Specifically, the manifold 60 is a manifold that is formed by joining and integrating a first housing 61 and a second housing 62 with each other and in which the plurality of flow paths through which cooling water is to be flowed are formed by the integration. On the first housing 61, the rotary valve 10, the first water pump 40, and the second water pump 50 are attached by bolts or the like. All of the rotary valve 10, the first water pump 40, and the second water pump 50 are attached on the opposite side of the first housing 61 to the side on which the second housing 62 is attached. The second housing 62 has a rectangular plate shape. A rotation axis X of the rotary valve 10, a rotation axis Y of the first water pump 40, and a rotation axis Z of the second water pump 50 are parallel with one another, and all of the rotation axes X, Y, and Z are perpendicular to a plate surface of the second housing 62. Note that operation of the rotary valve 10, the first water pump 40, and the second water pump 50 is controlled by a not-illustrated control unit.

### [Configuration of Manifold]

As illustrated in Fig. 1, in the first housing 61 of the manifold 60 of the present embodiment, a plurality of ports through which cooling water flows in from the outside or cooling water flows out to the outside are formed. In the present embodiment, nine ports including the first port 64a, the second port 64b, the third port 64c, the fourth port 64d, the fifth port 64e, the sixth port 64f, the seventh port 64g, the eighth port 64h, and the ninth port 64i are formed.

In the manifold 60, the plurality of flow paths are arranged in such a way as to be arranged in two layers. Specifically, the plurality of flow paths are divided into two layers by being partitioned by a plate-shaped partition portion (not illustrated) that is formed in the first housing 61 and that is parallel with the plate surface of the second housing 62. Hereinafter, of the plurality of flow paths arranged in two layers, a flow path formed on the second housing 62 side of the partition portion and over the first housing 61 and the second housing 62 is referred to as a lower-layer flow path. On the other hand, in the first housing 61, a flow path formed on the opposite side (the side on which the rotary valve 10, the first water pump 40, and the second water pump 50 are arranged) of the partition portion to a lower-layer flow path is referred to as an upper-layer flow path. In addition, a layer in which an upper-layer flow path is arranged and a layer in which a lower-layer flow path is arranged are referred to as an upper layer UL and a lower layer LL, respectively.

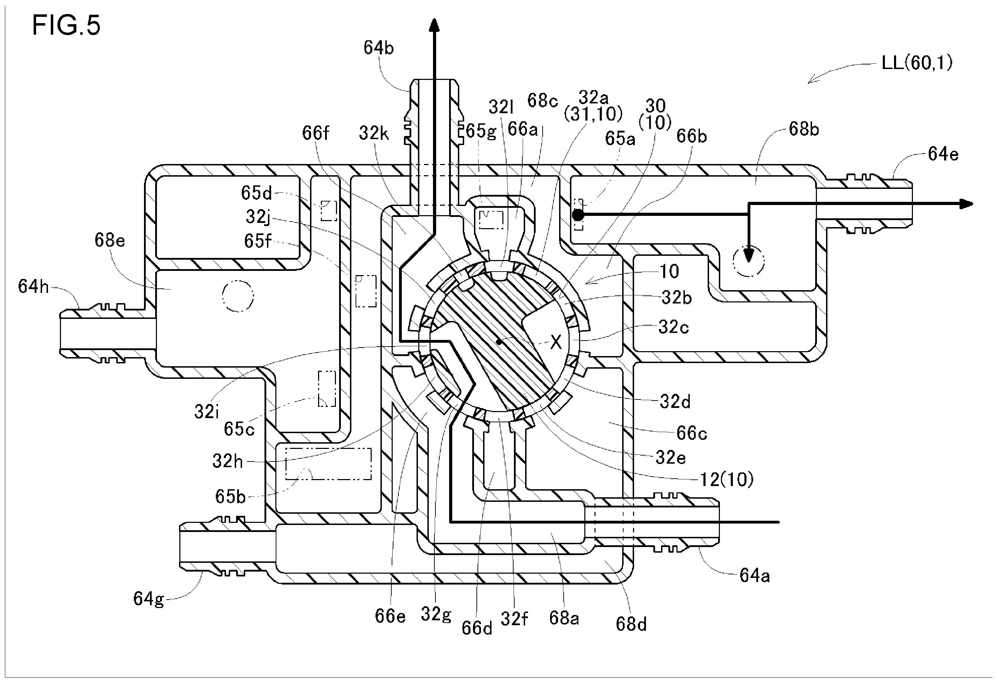

The rotary valve 10, the first water pump 40, and the second water pump 50 are arranged on the manifold 60 in a positional relationship in which the rotary valve 10 is sandwiched between the first water pump 40 and the second water pump 50. In the first housing 61 of the manifold 60, a bottomed cylindrical valve chamber 30 (see Fig. 5) in which a valve body 12 of the rotary valve 10 and a sealing material 31 are housed, a first vortex chamber (not illustrated) in which an impeller (not illustrated) of the first water pump 40 is housed, and a second vortex chamber (not illustrated) in which an impeller (not illustrated) of the second water pump 50 is housed are integrally formed with the first housing 61. The valve chamber 30 is a portion of the rotary valve 10. The first vortex chamber is a portion of the first water pump 40. The second vortex chamber is a portion of the second water pump 50. A specific configuration of the rotary valve 10 will be described later.

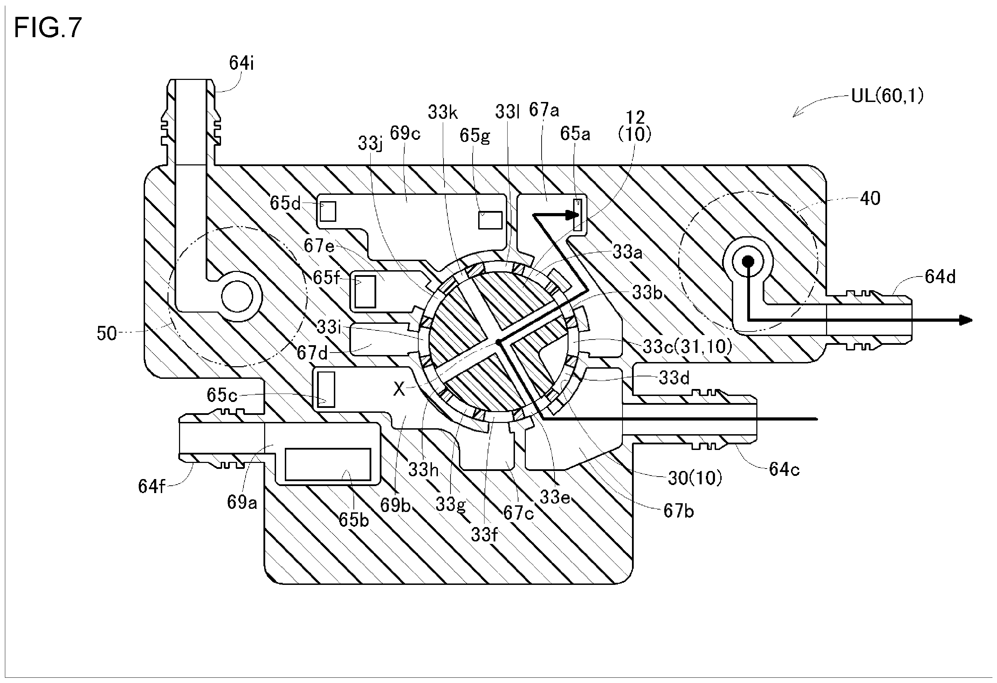

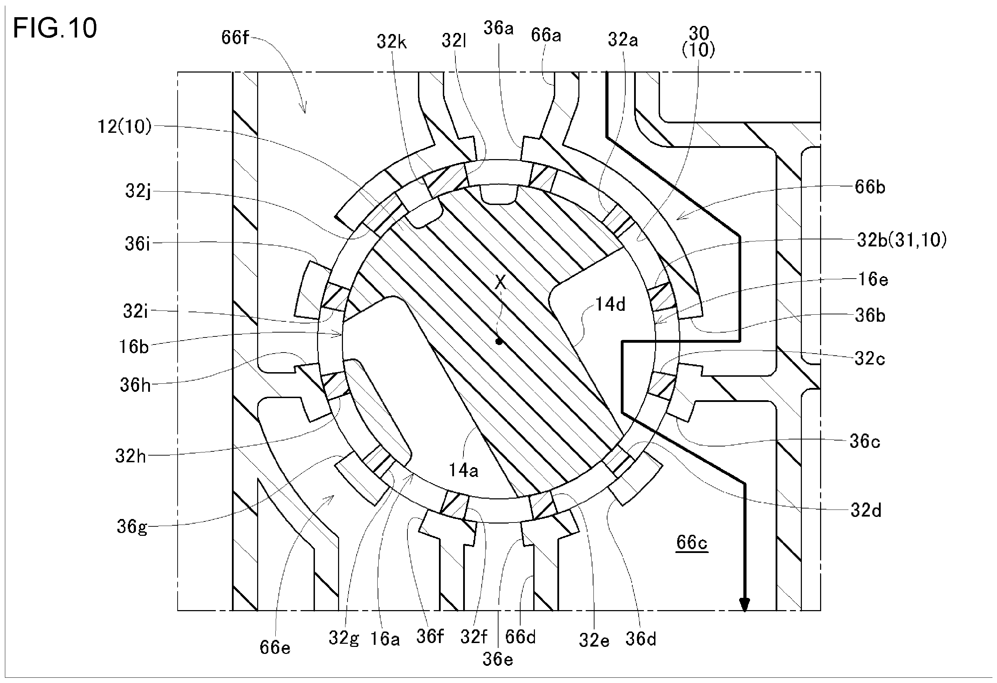

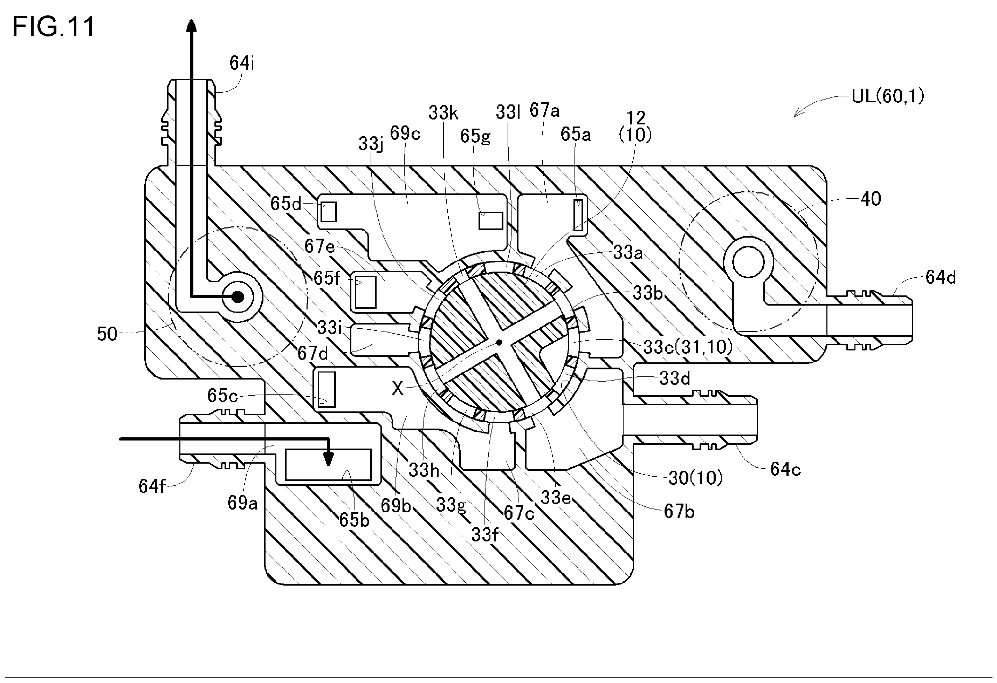

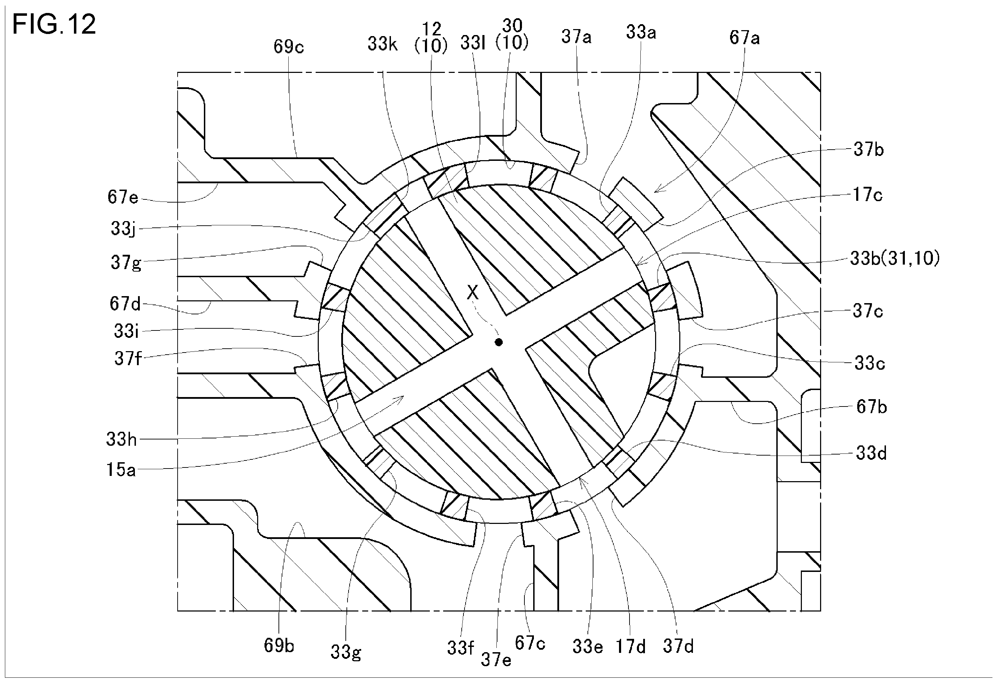

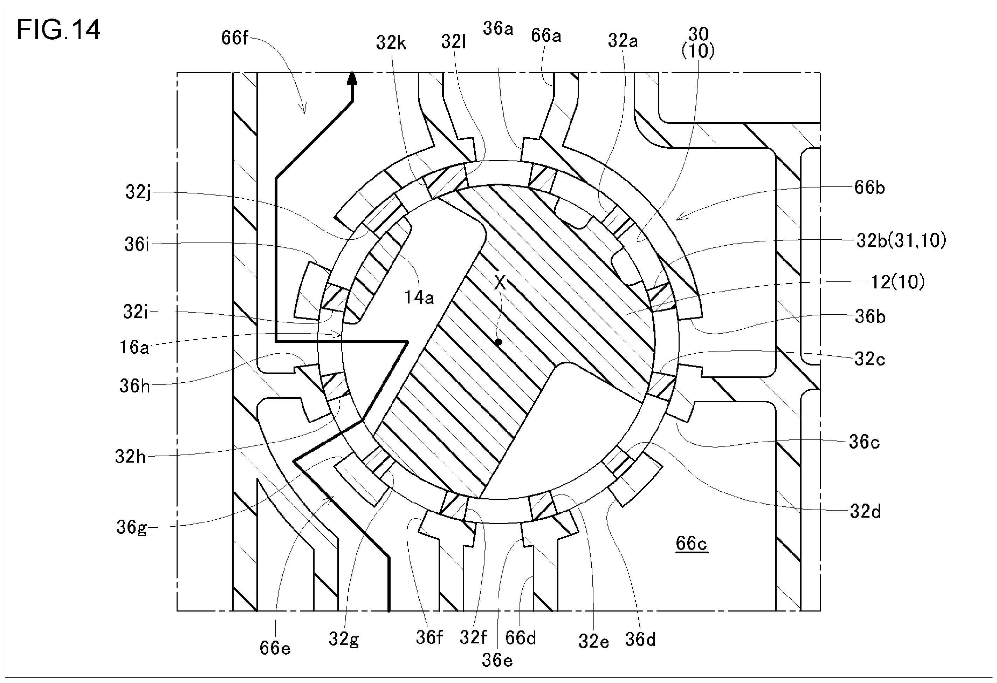

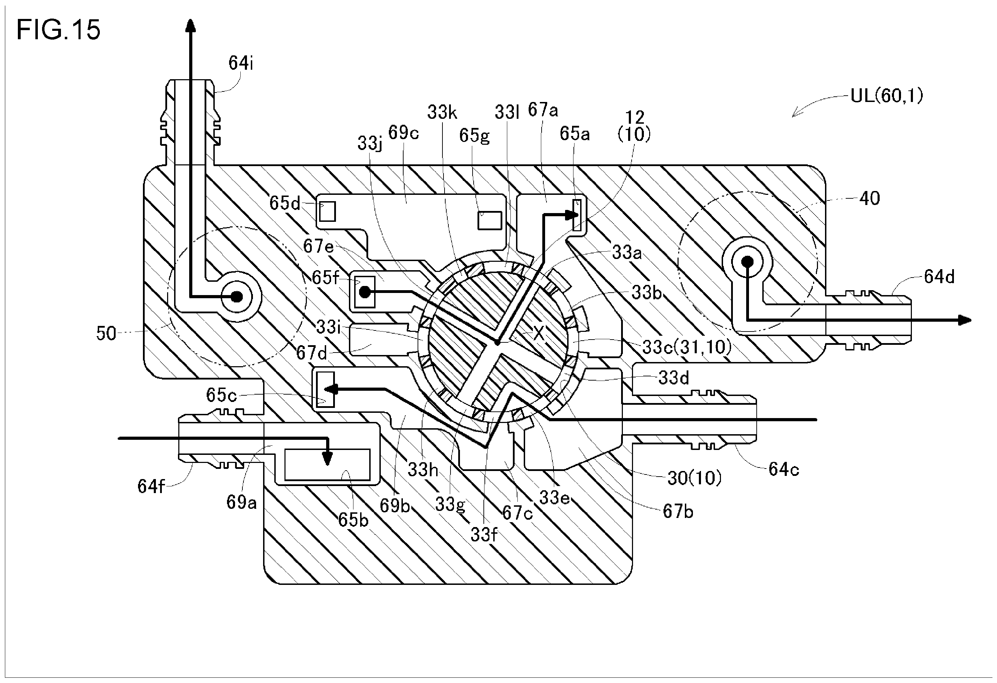

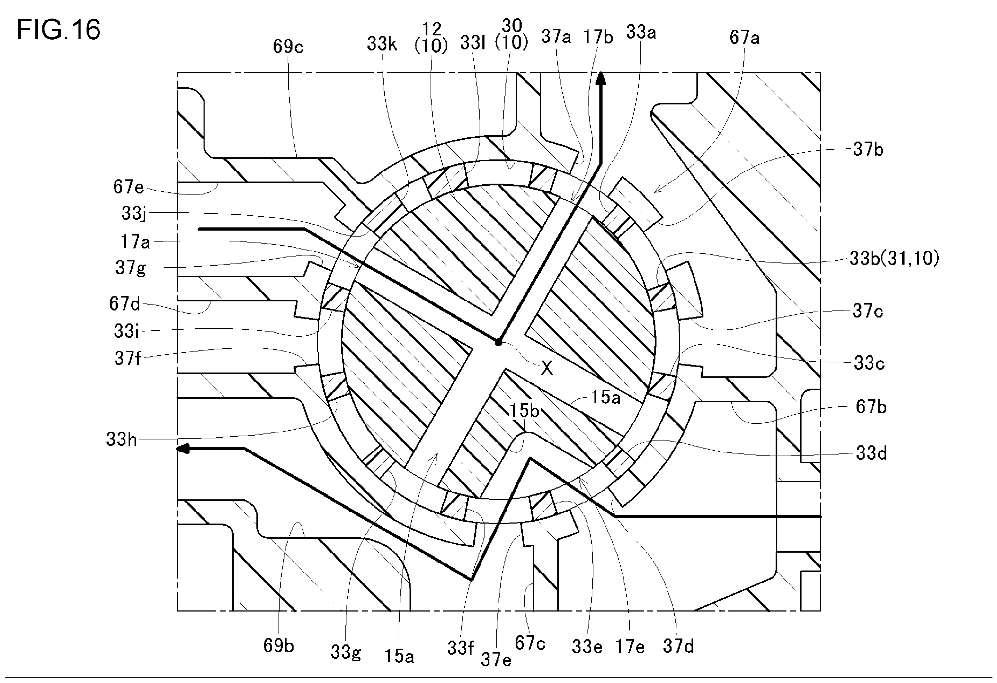

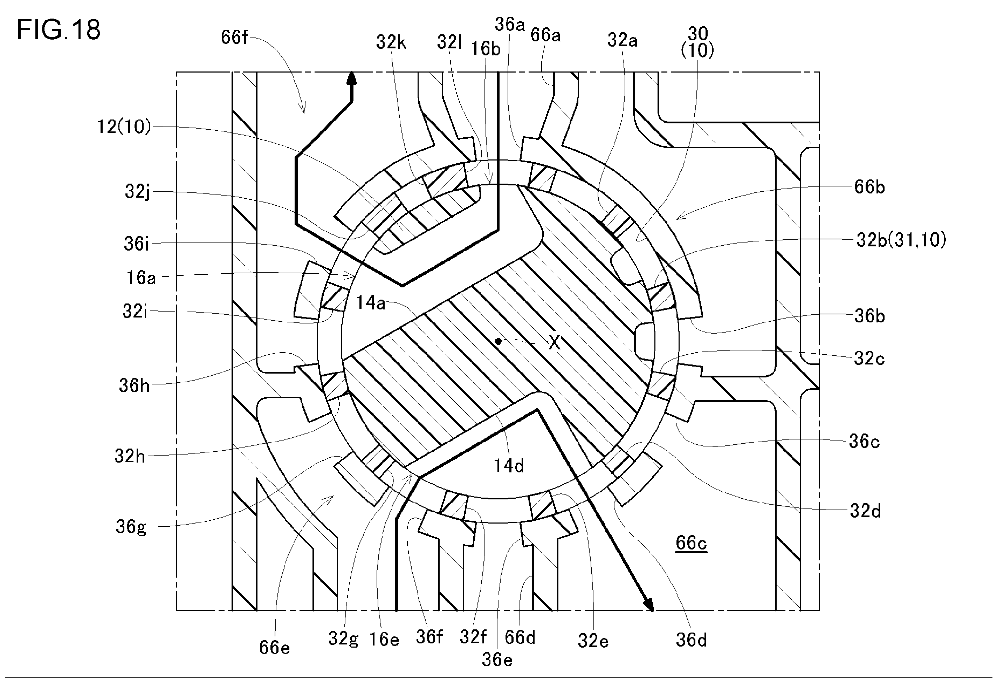

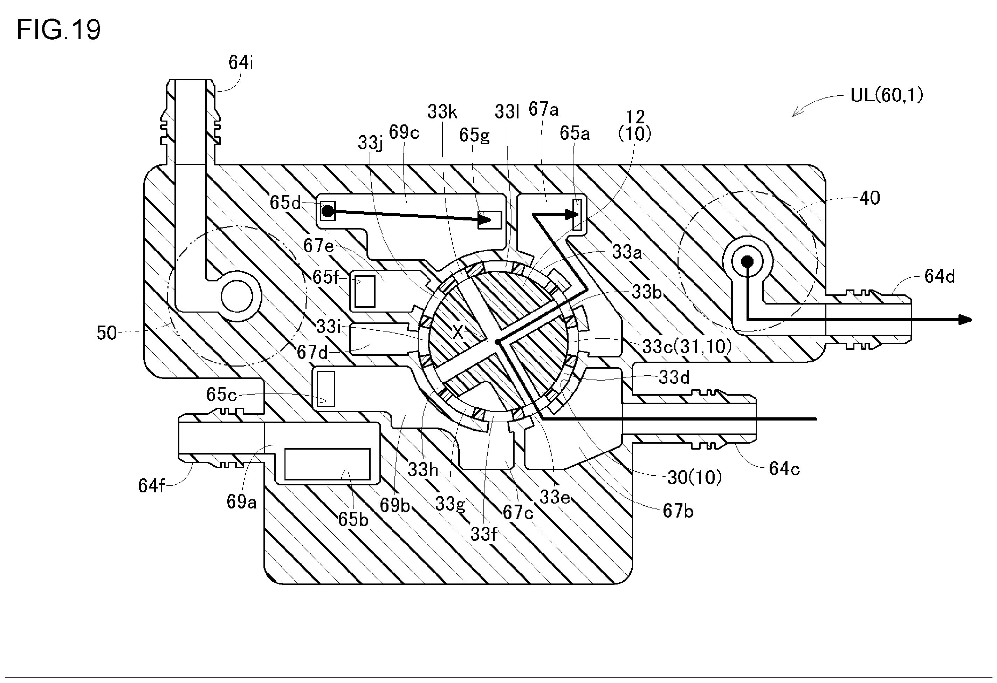

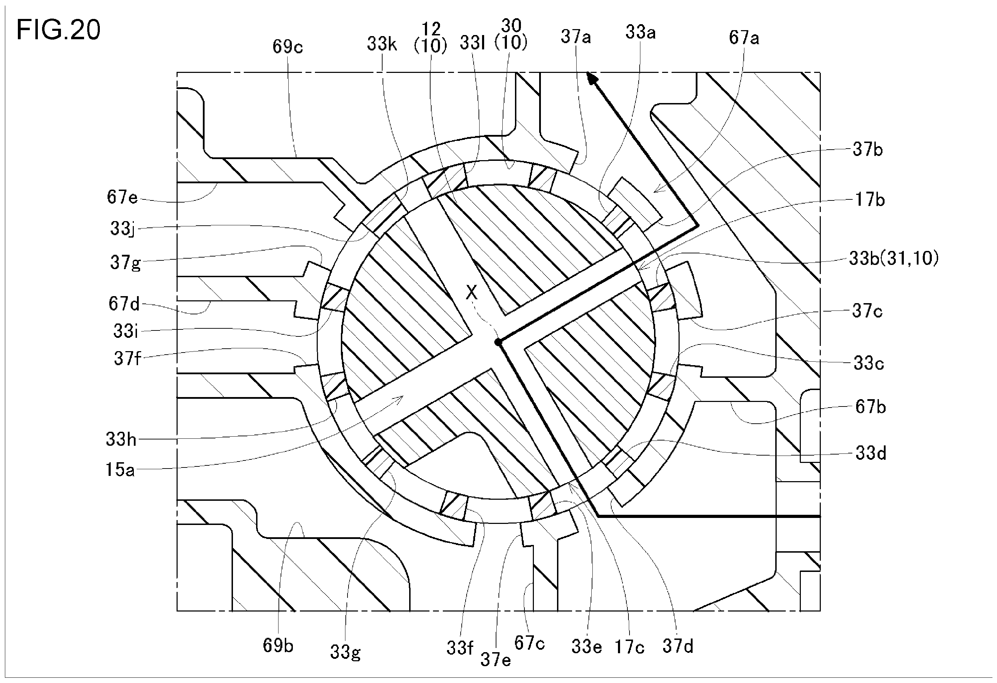

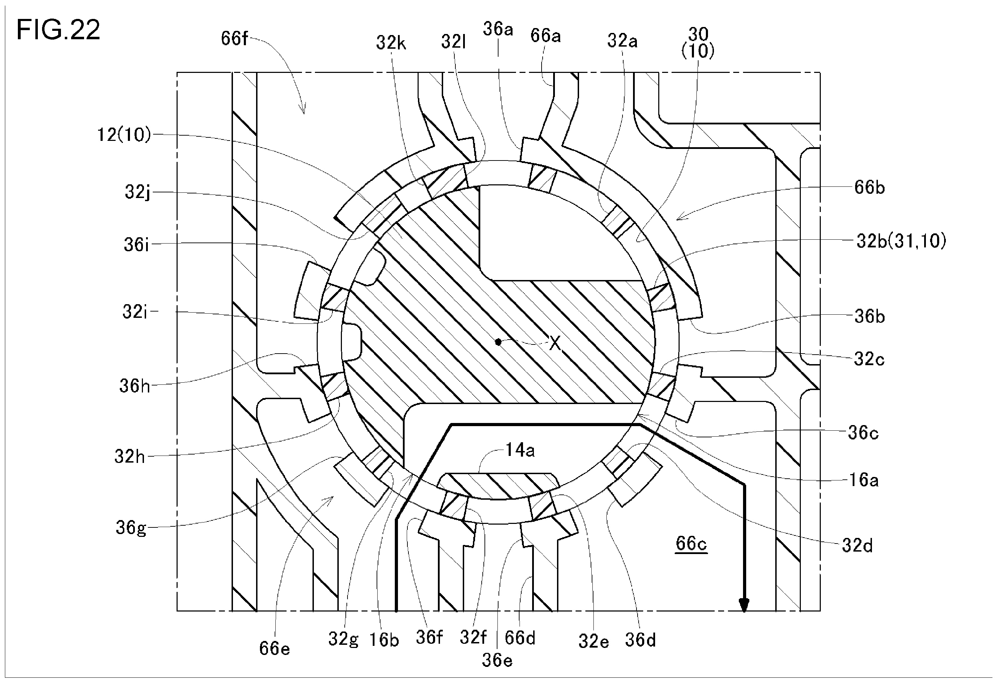

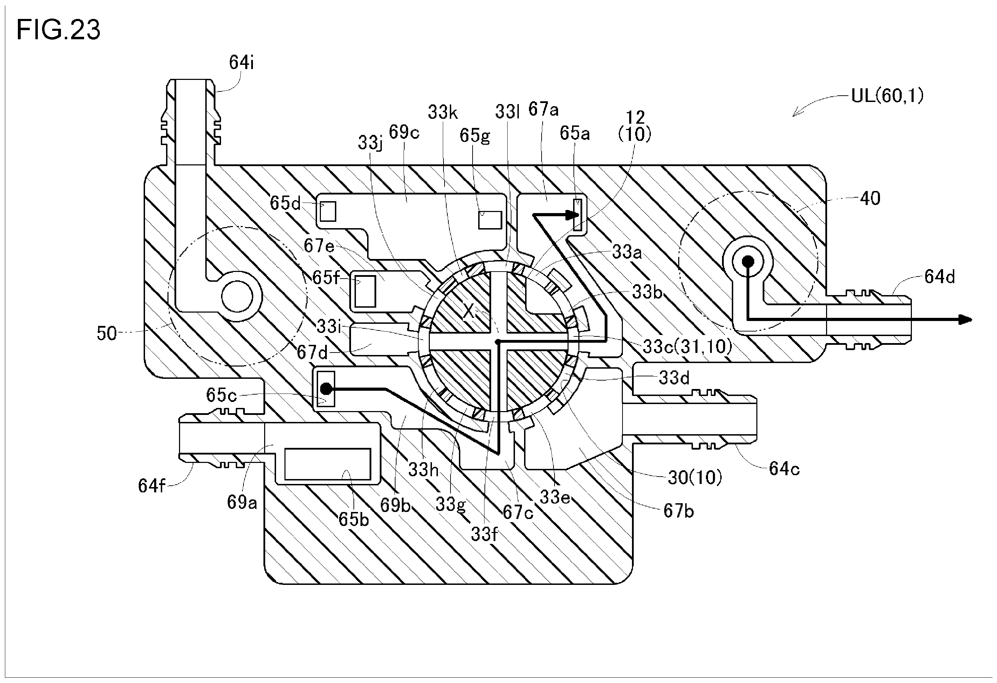

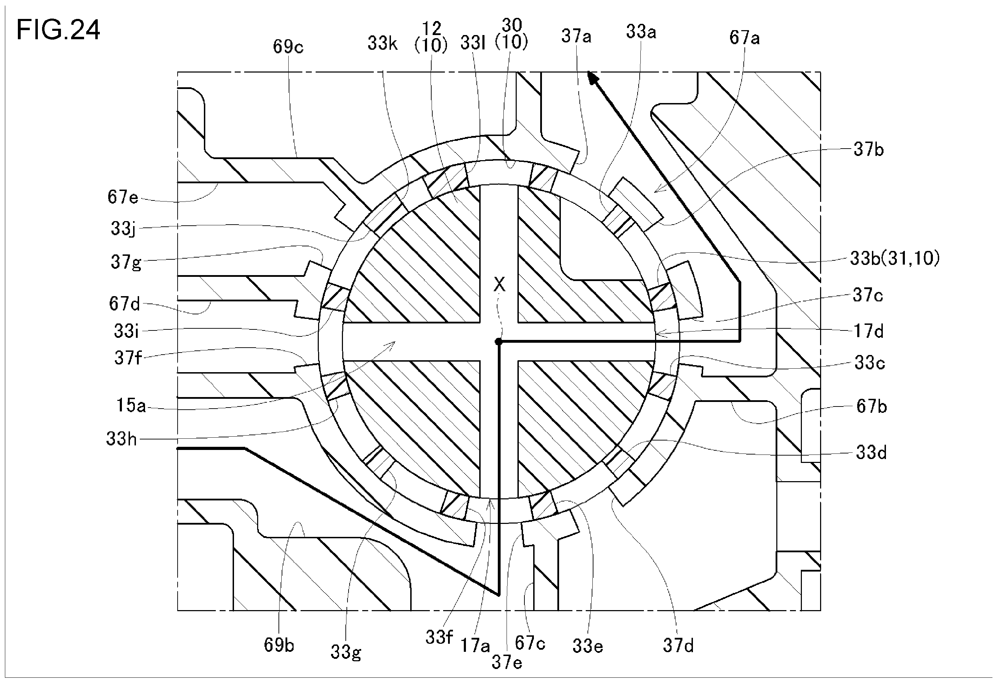

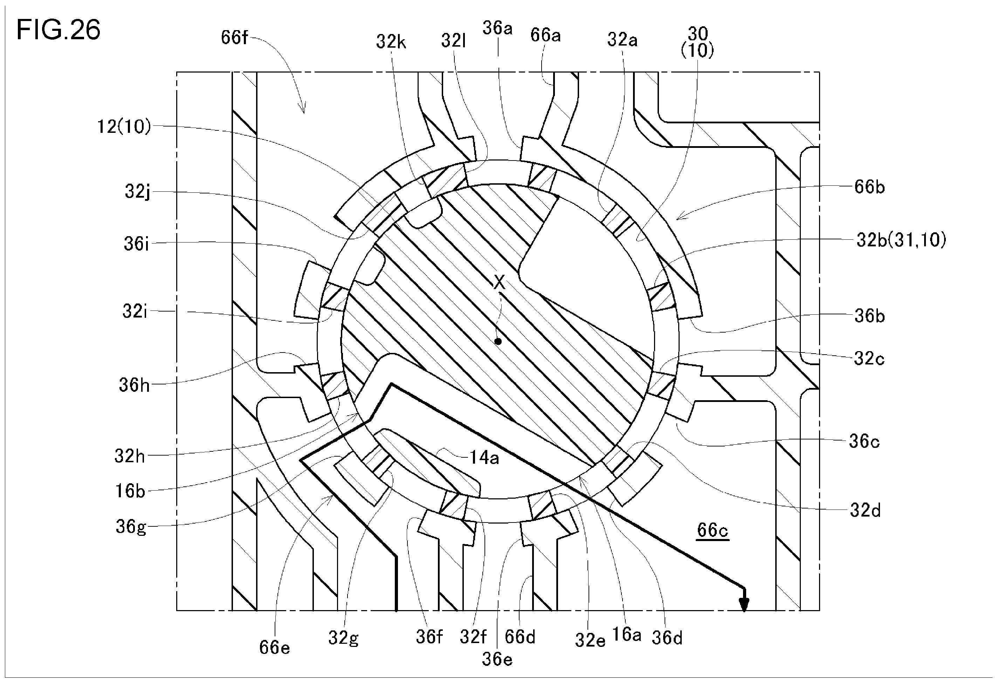

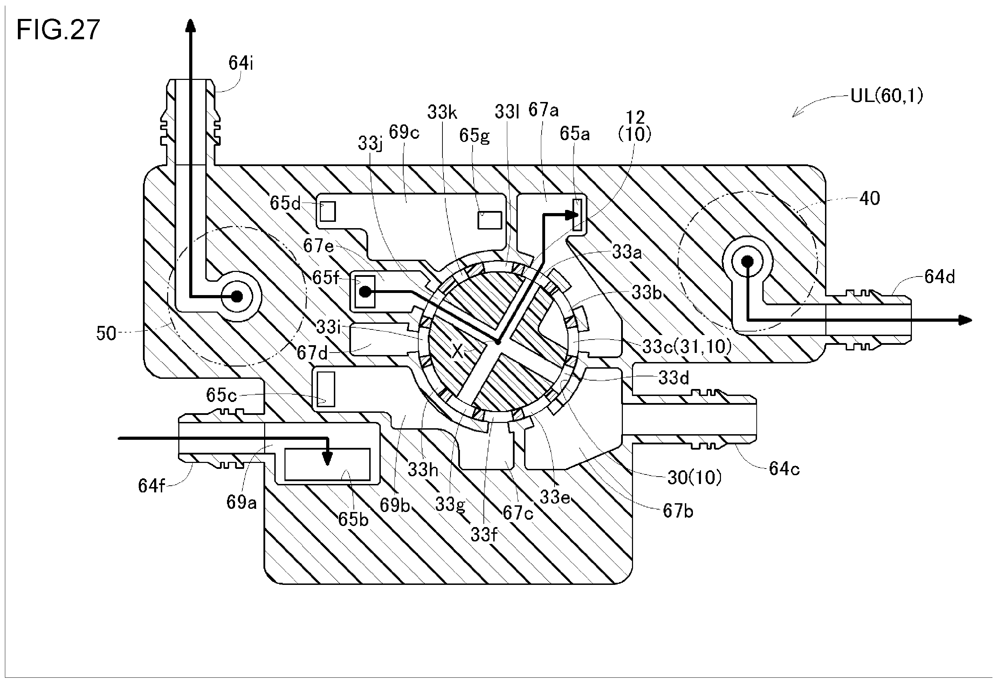

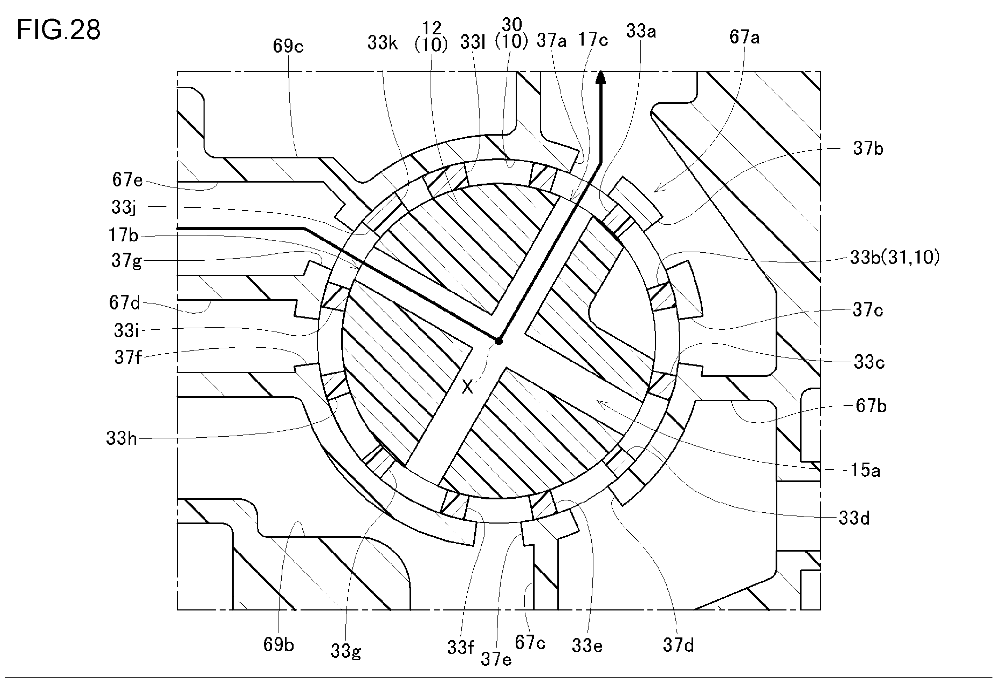

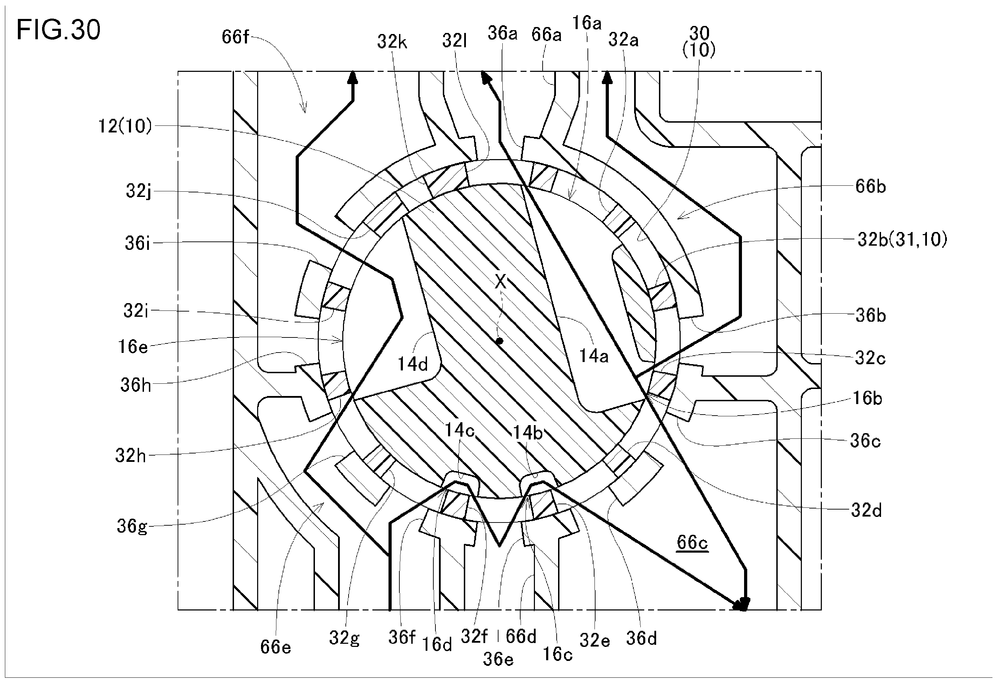

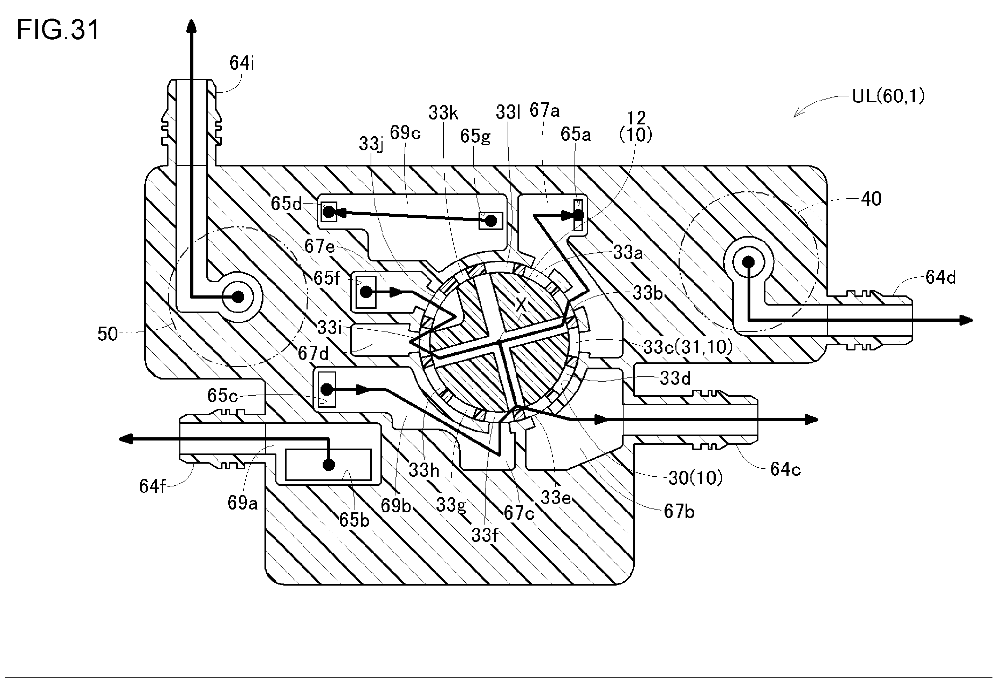

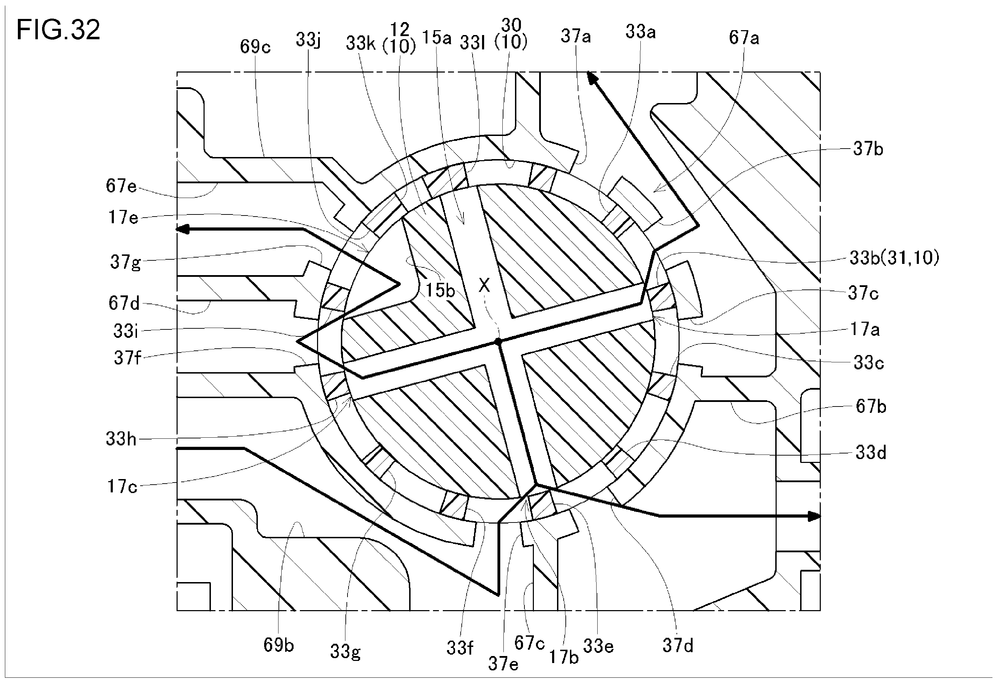

In surroundings of the valve chamber 30, a plurality of preliminary chambers are arranged in each of the upper layer UL and the lower layer LL. Specifically, as illustrated in Figs. 5 to 32, in the upper layer UL, five preliminary chambers including a first upper-layer preliminary chamber 67a (an example of a preliminary chamber), a second upper-layer preliminary chamber 67b (another example of the preliminary chamber), a third upper-layer preliminary chamber 67c (still another example of the preliminary chamber), a fourth upper-layer preliminary chamber 67d (still another example of the preliminary chamber), and a fifth upper-layer preliminary chamber 67e (still another example of the preliminary chamber) are arranged. In the lower layer LL, six preliminary chambers including a first lower-layer preliminary chamber 66a (an example of the preliminary chamber), a second lower-layer preliminary chamber 66b (another example of the preliminary chamber), a third lower-layer preliminary chamber 66c (still another example of the preliminary chamber), a fourth lower-layer preliminary chamber 66d (still another example of the preliminary chamber), a fifth lower-layer preliminary chamber 66e (still another example of the preliminary chamber), and a sixth lower-layer preliminary chamber 66f (still another example of the preliminary chamber) are arranged.

In a cylindrical wall separating the valve chamber 30 and preliminary chambers from each other in the manifold 60, a plurality of holes that communicate the valve chamber 30 and the preliminary chambers with each other are arranged in each of the upper layer UL and the lower layer LL. Specifically, as illustrated in Figs. 5 to 32, in the upper layer UL, seven communication holes including a first upper-layer hole 37a, a second upper-layer hole 37b, a third upper-layer hole 37c, a fourth upper-layer hole 37d, a fifth upper-layer hole 37e, a sixth upper-layer hole 37f, and a seventh upper-layer hole 37g are arranged. In the lower layer LL, nine communication holes including a first lower-layer hole 36a, a second lower-layer hole 36b, a third lower-layer hole 36c, a fourth lower-layer hole 36d, a fifth lower-layer hole 36e, a sixth lower-layer hole 36f, a seventh lower-layer hole 36g, an eighth lower-layer hole 36h, and a ninth lower-layer hole 36i are arranged. The plurality of upper-layer holes formed in the upper layer UL and the plurality of lower-layer holes formed in the lower layer LL are not connected to each other.

In the manifold 60, a plurality of flow paths and a plurality of communication holes that interconnect the plurality of preliminary chambers and the plurality of ports to each other are formed. The communication holes are holes that are formed in the partition portion (not illustrated) partitioning the inside of the manifold 60 into the upper layer UL and the lower layer LL and that communicate the upper layer UL and the lower layer LL with each other. Specifically, the first port 64a is connected to the fifth lower-layer preliminary chamber 66e via a first lower-layer flow path 68a (an example of an internal flow path). The fourth port 64d is connected to the first upper-layer preliminary chamber 67a via the first water pump 40, a second lower-layer flow path 68b (another example of the internal flow path), and a first communication hole 65a (still another example of the internal flow path). The fifth port 64e is connected to the first upper-layer preliminary chamber 67a via the second lower-layer flow path 68b and the first communication hole 65a.

The sixth port 64f is connected to the second lower-layer preliminary chamber 66b via a first upper-layer flow path 69a (still another example of the internal flow path), a second communication hole 65b (still another example of the internal flow path), and a third lower-layer flow path 68c (still another example of the internal flow path). In addition, the sixth port 64f is connected to the fifth upper-layer preliminary chamber 67e via the first upper-layer flow path 69a, the second communication hole 65b, the third lower-layer flow path 68c, and a sixth communication hole 65f. The seventh port 64g is connected to the third lower-layer preliminary chamber 66c via a fourth lower-layer flow path 68d (still another example of the internal flow path).

The eighth port 64h is connected to the third upper-layer preliminary chamber 67c via a fifth lower-layer flow path 68e (still another example of the internal flow path), a third communication hole 65c (still another example of the internal flow path), and a second upper-layer flow path 69b (still another example of the internal flow path). In addition, the eighth port 64h is connected to the first lower-layer preliminary chamber 66a via the fifth lower-layer flow path 68e, a fourth communication hole 65d (still another example of the internal flow path), a third upper-layer flow path 69c (still another example of the internal flow path), and a seventh communication hole 65g. The ninth port 64i is connected to the fifth lower-layer flow path 68e via the second water pump 50, and a connection path after the fifth lower-layer flow path 68e is the same as the connection path from the eighth port 64h. Note that the second port 64b is directly connected to the sixth lower-layer preliminary chamber 66f, and the third port 64c is directly connected to the second upper-layer preliminary chamber 67b.

### [Configuration of Valve Body of Rotary Valve]

Next, the rotary valve 10 of the present embodiment will be described. The rotary valve 10 includes, as illustrated in Figs. 5 to 32, the valve body 12, the valve chamber 30, and the sealing material 31. The valve chamber 30 is integrally formed with the manifold 60, as described above. The sealing material 31 is arranged in an annular shape along an inner circumferential surface of the valve chamber 30, and the valve body 12 is arranged on the radially inner side of the sealing material 31. The sealing material 31 comes into close contact with the inner circumferential surface of the valve chamber 30 and an outer circumferential surface of the valve body 12 and prevents cooling water from leaking from a flow path. The sealing material 31 is fixed to the first housing 61 in a non-rotatable manner by a known method, and the sealing material 31 never rotates even when the valve body 12 rotates.

In the sealing material 31, as illustrated in Figs. 5 to 32, in the upper layer UL, twelve communication holes including a first upper-layer sealing hole 33a, a second upper-layer sealing hole 33b, a third upper-layer sealing hole 33c, a fourth upper-layer sealing hole 33d, a fifth upper-layer sealing hole 33e, a sixth upper-layer sealing hole 33f, a seventh upper-layer sealing hole 33g, an eighth upper-layer sealing hole 33h, a ninth upper-layer sealing hole 33i, a tenth upper-layer sealing hole 33j, an eleventh upper-layer sealing hole 33k, and a twelfth upper-layer sealing hole 331 are arranged. In the lower layer LL, twelve communication holes including a first lower-layer sealing hole 32a, a second lower-layer sealing hole 32b, a third lower-layer sealing hole 32c, a fourth lower-layer sealing hole 32d, a fifth lower-layer sealing hole 32e, a sixth lower-layer sealing hole 32f, a seventh lower-layer sealing hole 32g, an eighth lower-layer sealing hole 32h, a ninth lower-layer sealing hole 32i, a tenth lower-layer sealing hole 32j, an eleventh lower-layer sealing hole 32k, and a twelfth lower-layer sealing hole 32l are arranged. The plurality of upper-layer sealing holes formed in the upper layer UL and the plurality of lower-layer sealing holes formed in the lower layer LL are not connected to each other.

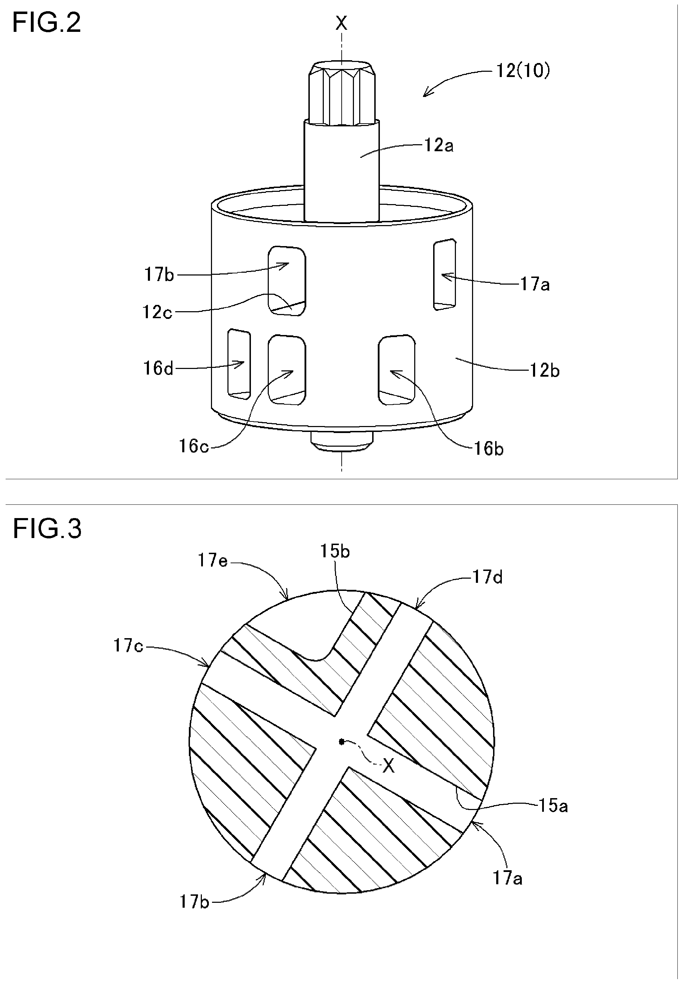

The valve body 12 is housed in the valve chamber 30 that is formed in the first housing 61 of the manifold 60 and controls flow of cooling water by rotating about the rotation axis X. As illustrated in Figs. 2 to 4, the valve body 12 includes a rotation shaft 12a that rotates about the rotation axis X and a circular column-shaped valve main body 12b that is connected to the rotation shaft 12a and that rotates about the rotation axis X. Inside the valve main body 12b, a plurality of flow-through holes are formed. Specifically, the valve main body 12b includes upper-layer flow-through holes that control flow of cooling water flowing in the upper layer UL and lower-layer flow-through holes that control flow of cooling water flowing in the lower layer LL. The upper-layer flow-through holes and the lower-layer flow-through holes are separated from each other by a partition plate 12c and are independent flow-through holes. The upper-layer flow-through holes are formed in a part located on the upper side of the partition plate 12c, and the lower-layer flow-through holes are formed in a part located on the lower side of the partition plate 12c.

As illustrated in Fig. 3, the upper-layer flow-through holes include a first upper-layer flow-through hole 15a that is formed to have a cross-shaped cross section crossing at right angles at a point overlapping the rotation axis X and a second upper-layer flow-through hole 15b that is formed to have a fan-shaped cross section. The first upper-layer flow-through hole 15a includes a first upper-layer opening 17a, a second upper-layer opening 17b, a third upper-layer opening 17c, and a fourth upper-layer opening 17d that are arranged on a surface (outer circumferential surface) of the valve main body 12b in order in a clockwise direction illustrated in Fig. 3. That is, the first upper-layer opening 17a, the second upper-layer opening 17b, the third upper-layer opening 17c, and the fourth upper-layer opening 17d are connected to one another via the first upper-layer flow-through hole 15a. The second upper-layer flow-through hole 15b is arranged between the third upper-layer opening 17c and the fourth upper-layer opening 17d in the circumferential direction of the valve main body 12b. The second upper-layer flow-through hole 15b includes a fifth upper-layer opening 17e on the surface of the valve main body 12b. Circumferential length of the fifth upper-layer opening 17e is longer than circumferential lengths of the first upper-layer opening 17a, the second upper-layer opening 17b, the third upper-layer opening 17c, and the fourth upper-layer opening 17d. The circumferential lengths of the first upper-layer opening 17a, the second upper-layer opening 17b, the third upper-layer opening 17c, and the fourth upper-layer opening 17d are the same as one another. As described above, a multi-directional valve is formed by the upper-layer flow-through holes formed in the upper layer UL of the valve body 12 and the valve chamber 30.

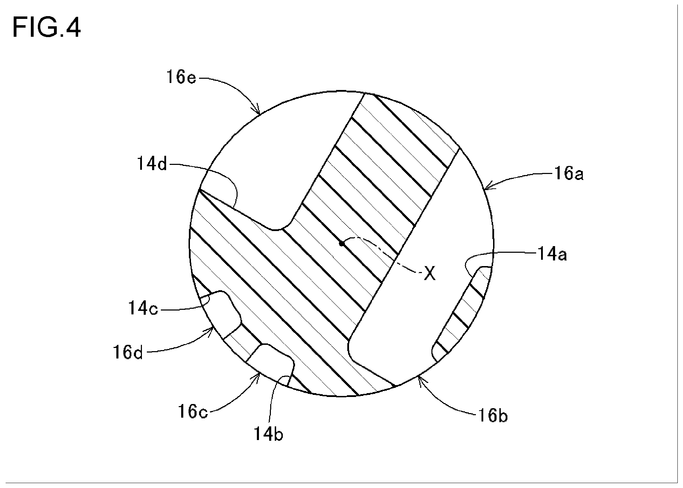

As illustrated in Fig. 4, the lower-layer flow-through holes include a first lower-layer flow-through hole 14a, a second lower-layer flow-through hole 14b, a third lower-layer flow-through hole 14c, and a fourth lower-layer flow-through hole 14d. The first lower-layer flow-through hole 14a includes a first lower-layer opening 16a and a second lower-layer opening 16b on the surface of the valve main body 12b. That is, the first lower-layer opening 16a and the second lower-layer opening 16b are connected to each other via the first lower-layer flow-through hole 14a and are adjacent to each other in the circumferential direction. Each of the second lower-layer flow-through hole 14b and the third lower-layer flow-through hole 14c has a cross section formed in a substantially trapezoidal shape. The second lower-layer flow-through hole 14b includes a third lower-layer opening 16c on the surface of the valve main body 12b, and the third lower-layer flow-through hole 14c includes a fourth lower-layer opening 16d on the surface of the valve main body 12b. The fourth lower-layer flow-through hole 14d has a cross section formed in a substantially fan shape and includes a fifth lower-layer opening 16e on the surface of the valve main body 12b. The first lower-layer opening 16a, the second lower-layer opening 16b, the third lower-layer opening 16c, the fourth lower-layer opening 16d, and the fifth lower-layer opening 16e are arranged on the surface of the valve main body 12b in this order in the clockwise direction illustrated in Fig. 4. Circumferential lengths of the second lower-layer opening 16b, the third lower-layer opening 16c, and the fourth lower-layer opening 16d are the same, circumferential length of the first lower-layer opening 16a is longer than the circumferential lengths of the foregoing, and circumferential length of the fifth lower-layer opening 16e is further longer than the circumferential length of the first lower-layer opening 16a. The circumferential length of the second lower-layer opening 16b, the third lower-layer opening 16c, and the fourth lower-layer opening 16d is the same as the circumferential length of the first upper-layer opening 17a, the second upper-layer opening 17b, the third upper-layer opening 17c, and the fourth upper-layer opening 17d. As described above, a multi-directional valve is formed by the lower-layer flow-through holes formed in the lower layer LL of the valve body 12 and the valve chamber 30.

As illustrated in Figs. 2 to 4, when viewed in plan, the second upper-layer opening 17b and the third lower-layer opening 16c are arranged at a position at which the second upper-layer opening 17b and the third lower-layer opening 16c overlap each other, and the first upper-layer opening 17a is arranged between the first lower-layer opening 16a and the second lower-layer opening 16b in the circumferential direction. The fourth lower-layer opening 16d is arranged between the second upper-layer opening 17b and the third upper-layer opening 17c in the circumferential direction. Both the third upper-layer opening 17c and the fifth upper-layer opening 17e are arranged at positions at which the third upper-layer opening 17c and the fifth upper-layer opening 17e overlap the fifth lower-layer opening 16e in the circumferential direction. The fourth upper-layer opening 17d is arranged between the first lower-layer opening 16a and the fifth lower-layer opening 16e as viewed in plan.

### [Operation in Regular Mode]

### [First Mode]

Next, operation of the cooling module 1 of the present embodiment in a regular mode will be described. The regular mode is a mode that is set when a motor of an electric vehicle is energized, such as while the electric vehicle is in a warm-up operation, is traveling, and is temporarily stopped. The regular mode includes first to sixth modes. Note that as described above, the operation of the rotary valve 10, the first water pump 40, and the second water pump 50 is controlled by the not-illustrated control unit. Hereinafter, except when necessary, it is not explicitly stated that rotation of the rotary valve 10 and start and stop of the first water pump 40 and the second water pump 50 are controlled by the control unit.

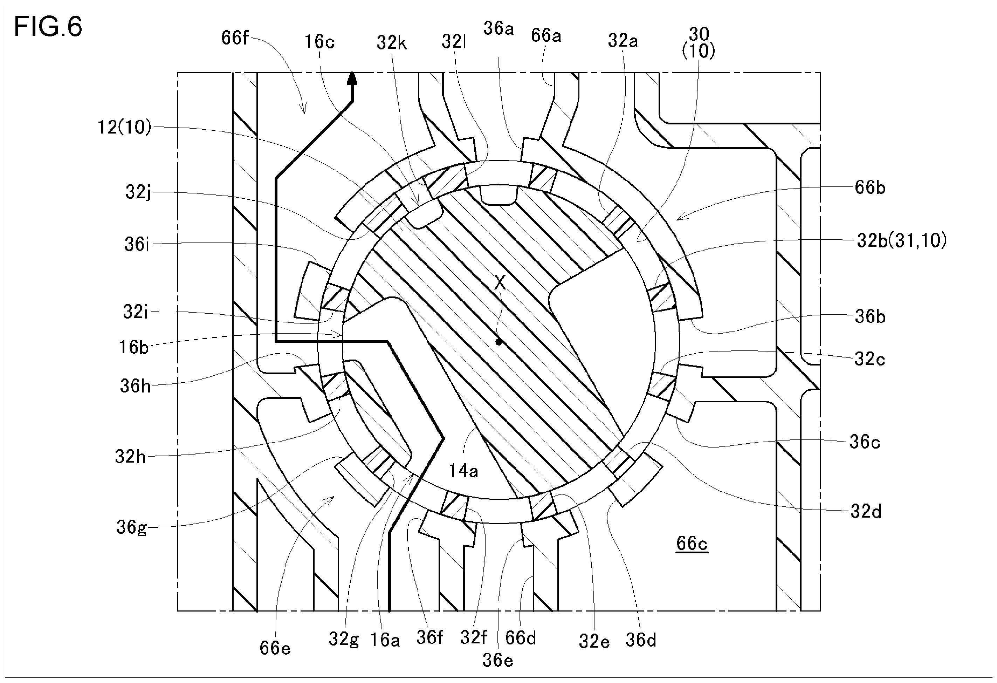

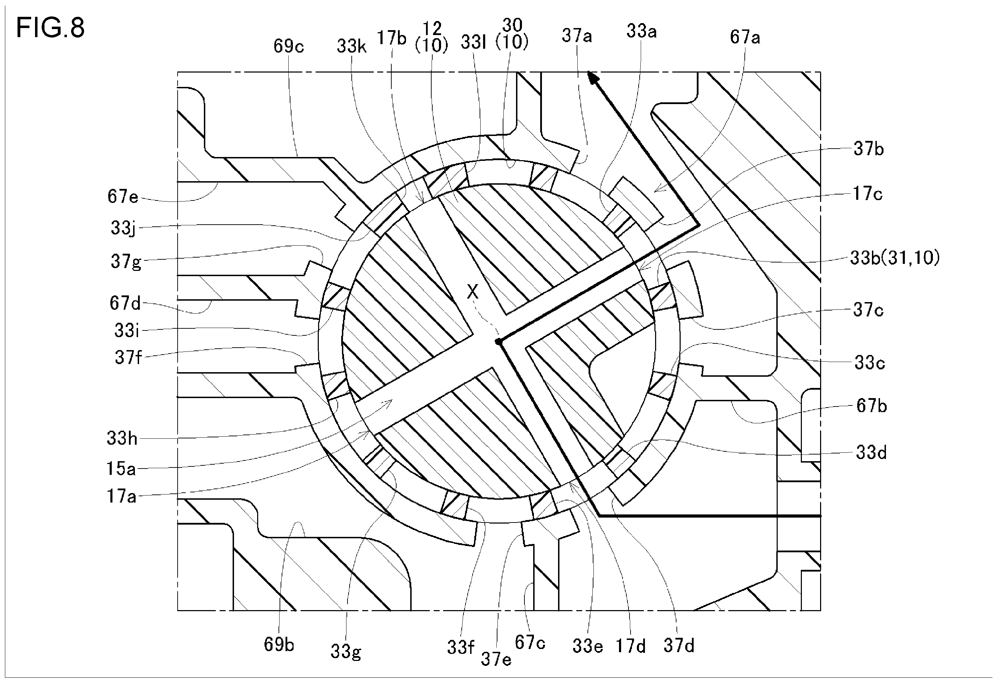

In the first mode, as illustrated in Figs. 5 to 8, the valve body 12 of the rotary valve 10 is rotated 30 degrees from a reference position in the counterclockwise direction, and the first water pump 40 is in operation and the second water pump 50 is stopped. The reference position of the valve body 12 is a position at which the second upper-layer opening 17b and the third lower-layer opening 16c face vertically upward in the vertical direction illustrated in Figs. 5 to 8 (see Figs. 6 and 8). When the valve body 12 is positioned at the reference position, the first upper-layer opening 17a faces horizontally leftward, the third upper-layer opening 17c faces horizontally rightward, and the fourth upper-layer opening 17d faces vertically downward.

In the first mode, as illustrated in Figs. 5 and 6, cooling water having flowed into the lower layer LL from the first port 64a flows through the first lower-layer flow path 68a, the fifth lower-layer preliminary chamber 66e, the sixth lower-layer hole 36f, the seventh lower-layer sealing hole 32g, the first lower-layer opening 16a, the first lower-layer flow-through hole 14a, the second lower-layer opening 16b, the ninth lower-layer sealing hole 32i, the eighth lower-layer hole 36h, and the sixth lower-layer preliminary chamber 66f and flows out from the second port 64b. The cooling water having flowed out from the second port 64b flows through a not-illustrated pipe and cools or heats a not-illustrated auxiliary machine.

In addition, in the first mode, as illustrated in Figs. 5 to 8, cooling water having flowed into the upper layer UL from the third port 64c flows through the second upper-layer preliminary chamber 67b, the fourth upper-layer hole 37d, the fifth upper-layer sealing hole 33e, the fourth upper-layer opening 17d, the first upper-layer flow-through hole 15a, the third upper-layer opening 17c, the second upper-layer sealing hole 33b, the second upper-layer hole 37b, the first upper-layer preliminary chamber 67a, the first communication hole 65a, and the second lower-layer flow path 68b and flows out from the fifth port 64e, and also flows from the second lower-layer flow path 68b to the first water pump 40, where being pressurized, and flows out from the fourth port 64d. The cooling water having flowed out from the fourth port 64d and the fifth port 64e flows through not-illustrated pipes and cools or heats not-illustrated auxiliary machines.

In the first mode, cooling water does not flow through the sixth port 64f, the seventh port 64g, the eighth port 64h, and the ninth port 64i.

### [Second Mode]

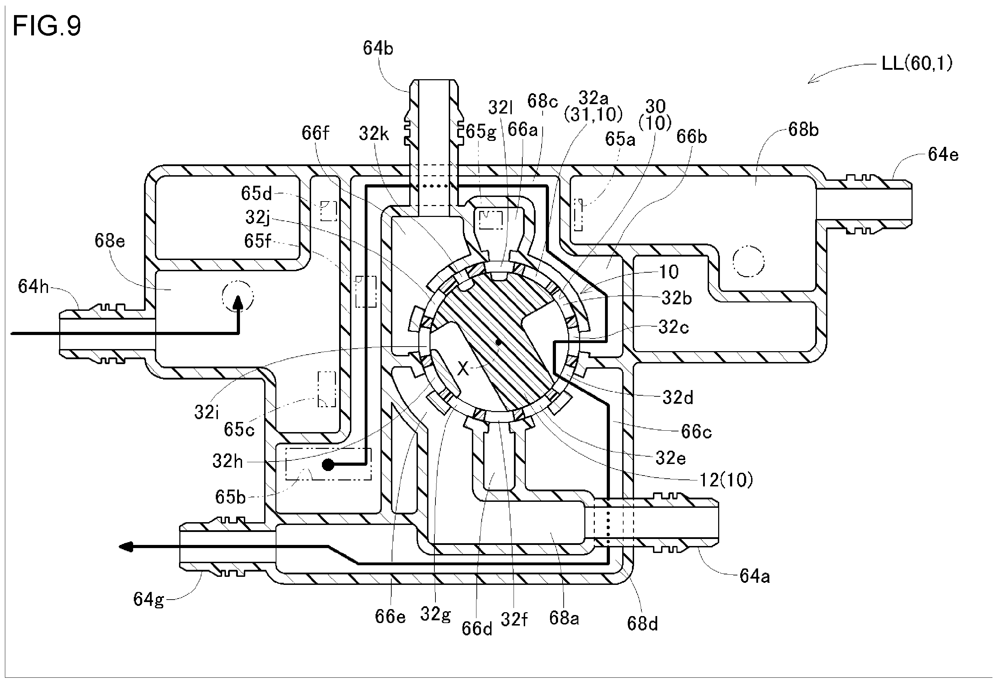

In the second mode, as illustrated in Figs. 9 to 12, the valve body 12 of the rotary valve 10 is rotated 30 degrees from the reference position in the counterclockwise direction, and the first water pump 40 is stopped and the second water pump 50 is in operation.

In the second mode, as illustrated in Fig. 9, cooling water having flowed into the fifth lower-layer flow path 68e in the lower layer LL from the eighth port 64h is pressurized in the second water pump 50 and flows out from the ninth port 64i. The cooling water having flowed out from the ninth port 64i flows through a not-illustrated pipe and cools or heats a not-illustrated auxiliary machine.

In addition, in the second mode, as illustrated in Figs. 9 to 11, cooling water having flowed into the upper layer UL from the sixth port 64f flows through the first upper-layer flow path 69a, the second communication hole 65b, the third lower-layer flow path 68c, the second lower-layer preliminary chamber 66b, the second lower-layer hole 36b, the third lower-layer sealing hole 32c, the fifth lower-layer opening 16e, the fourth lower-layer flow-through hole 14d, the fifth lower-layer opening 16e, the fourth lower-layer sealing hole 32d, the third lower-layer hole 36c, the third lower-layer preliminary chamber 66c, and the fourth lower-layer flow path 68d and flows out from the seventh port 64g. The cooling water having flowed out from the seventh port 64g flows through a not-illustrated pipe and cools or heats a not-illustrated auxiliary machine.

In the second mode, cooling water does not flow through the first port 64a, the second port 64b, the third port 64c, the fourth port 64d, and the fifth port 64e.

### [Third Mode]

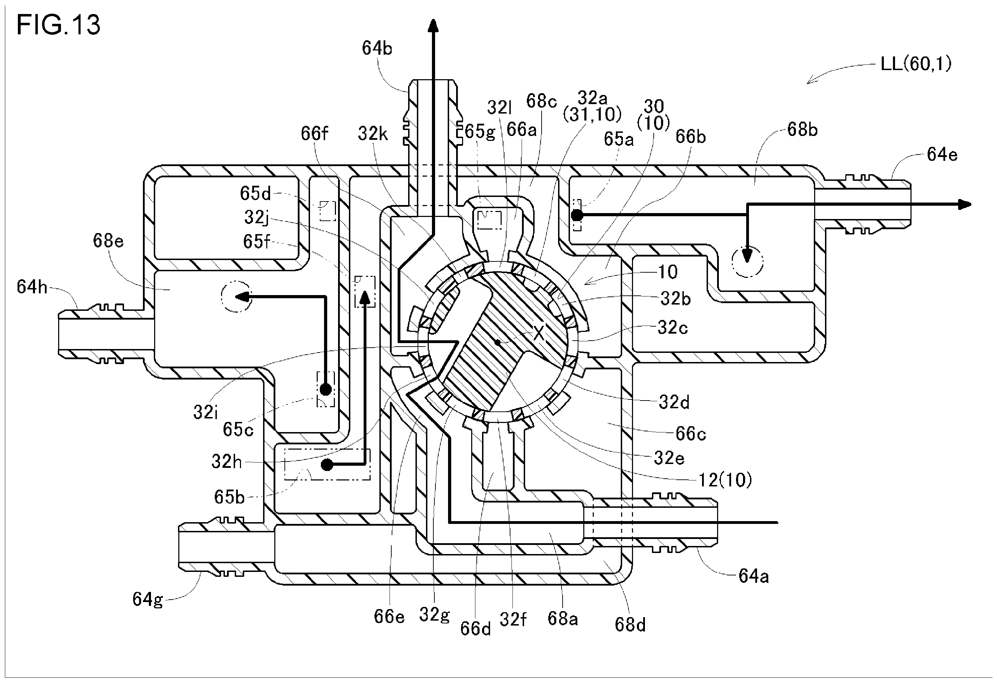

In the third mode, as illustrated in Figs. 13 to 16, the valve body 12 of the rotary valve 10 is rotated 30 degrees from the reference position in the clockwise direction, and the first water pump 40 and the second water pump 50 are in operation.

In the third mode, as illustrated in Figs. 13 to 16, cooling water having flowed into the lower layer LL from the first port 64a flows through the first lower-layer flow path 68a, the fifth lower-layer preliminary chamber 66e, the seventh lower-layer hole 36g, the eighth lower-layer sealing hole 32h, the first lower-layer opening 16a, the first lower-layer flow-through hole 14a, the first lower-layer opening 16a, the ninth lower-layer sealing hole 32i, the eighth lower-layer hole 36h, and the sixth lower-layer preliminary chamber 66f and flows out from the second port 64b. The cooling water having flowed out from the second port 64b flows through the not-illustrated pipe and cools or heats the not-illustrated auxiliary machine.

In addition, in the third mode, as illustrated in Figs. 13 to 16, cooling water having flowed into the upper layer UL from the third port 64c flows through the second upper-layer preliminary chamber 67b, the fourth upper-layer hole 37d, the fifth upper-layer sealing hole 33e, the fifth upper-layer opening 17e, the second upper-layer flow-through hole 15b, the fifth upper-layer opening 17e, the sixth upper-layer sealing hole 33f, the fifth upper-layer hole 37e, the third upper-layer preliminary chamber 67c, the second upper-layer flow path 69b, the third communication hole 65c, and the fifth lower-layer flow path 68e, is pressurized in the second water pump 50, and flows out from the ninth port 64i. The cooling water having flowed out from the ninth port 64i flows through the not-illustrated pipe and cools or heats the not-illustrated auxiliary machine.

Further, in the third mode, as illustrated in Figs. 13 to 16, cooling water having flowed into the upper layer UL from the sixth port 64f flows through the first upper-layer flow path 69a, the second communication hole 65b, the third lower-layer flow path 68c, the sixth communication hole 65f, the fifth upper-layer preliminary chamber 67e, the seventh upper-layer hole 37g, the tenth upper-layer sealing hole 33j, the first upper-layer opening 17a, the first upper-layer flow-through hole 15a, the second upper-layer opening 17b, the first upper-layer sealing hole 33a, the first upper-layer hole 37a, the fifth upper-layer preliminary chamber 67a, the first communication hole 65a, and the second lower-layer flow path 68b and flows out from the fifth port 64e, and also flows from the second lower-layer flow path 68b to the first water pump 40, where being pressurized, and flows out from the fourth port 64d. The cooling water having flowed out from the fourth port 64d and the fifth port 64e flows through the not-illustrated pipes and cools or heats the not-illustrated auxiliary machines.

In the third mode, cooling water does not flow through the seventh port 64g and the eighth port 64h.

### [Fourth Mode]

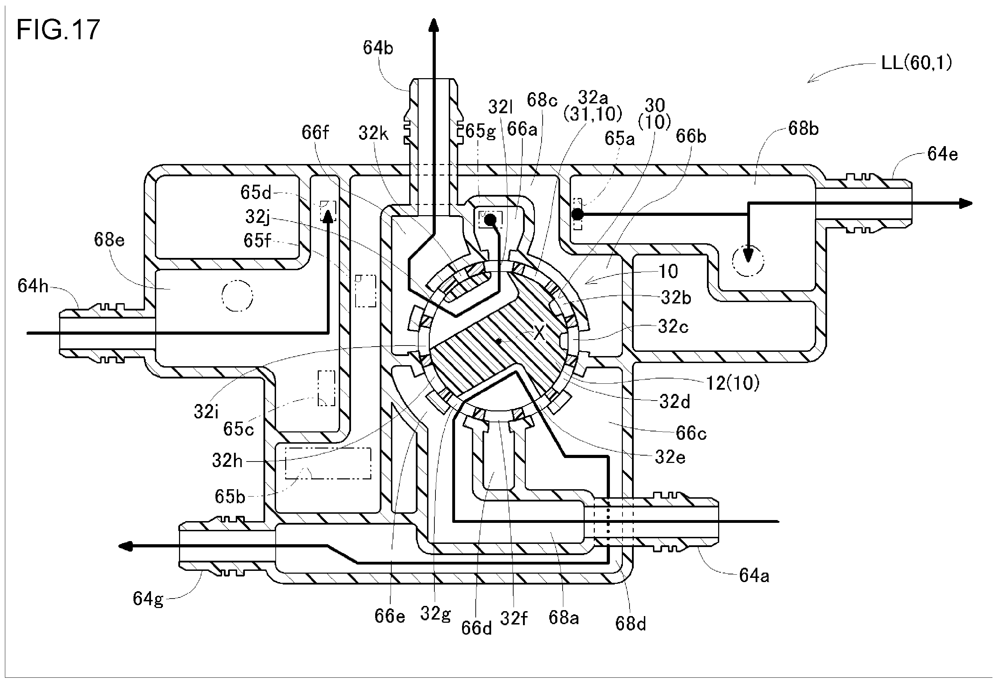

In the fourth mode, as illustrated in Figs. 17 to 20, the valve body 12 of the rotary valve 10 is rotated 60 degrees from the reference position in the clockwise direction, and the first water pump 40 is in operation and the second water pump 50 is stopped.

In the fourth mode, as illustrated in Figs. 17 to 20, cooling water having flowed into the lower layer LL from the first port 64a flows through the first lower-layer flow path 68a, the fifth lower-layer preliminary chamber 66e, the sixth lower-layer hole 36f, the seventh lower-layer sealing hole 32g, the fifth lower-layer opening 16e, the fourth lower-layer flow-through hole 14d, the fifth lower-layer opening 16e, the fifth lower-layer sealing hole 32e, the fourth lower-layer hole 36d, the third lower-layer preliminary chamber 66c, and the fourth lower-layer flow path 68d and flows out from the seventh port 64g. The cooling water having flowed out from the seventh port 64g flows through the not-illustrated pipe and cools or heats the not-illustrated auxiliary machine.

In addition, in the fourth mode, as illustrated in Figs. 17 to 20, cooling water having flowed into the lower layer LL from the eighth port 64h flows through the fifth lower-layer flow path 68e, the fourth communication hole 65d, the third upper-layer flow path 69c, the seventh communication hole 65g, the first lower-layer preliminary chamber 66a, the first lower-layer hole 36a, the twelfth lower-layer sealing hole 32l, the second lower-layer opening 16b, the first lower-layer flow-through hole 14a, the first lower-layer opening 16a, the tenth lower-layer sealing hole 32j, the ninth lower-layer hole 36i, and the sixth lower-layer preliminary chamber 66f and flows out from the second port 64b. The cooling water having flowed out from the second port 64b flows through the not-illustrated pipe and cools or heats the not-illustrated auxiliary machine.

In addition, in the fourth mode, as illustrated in Figs. 17 to 20, cooling water having flowed into the upper layer UL from the third port 64c flows through the second upper-layer preliminary chamber 67b, the fourth upper-layer hole 37d, the fifth upper-layer sealing hole 33e, the third upper-layer opening 17c, the first upper-layer flow-through hole 15a, the second upper-layer opening 17b, the second upper-layer sealing hole 33b, the second upper-layer hole 37b, the first upper-layer preliminary chamber 67a, the first communication hole 65a, and the second lower-layer flow path 68b and flows out from the fifth port 64e, and also flows from the second lower-layer flow path 68b to the first water pump 40, where being pressurized, and flows out from the fourth port 64d. The cooling water having flowed out from the fourth port 64d and the fifth port 64e flows through the not-illustrated pipes and cools or heats the not-illustrated auxiliary machines.

In the fourth mode, cooling water does not flow through the sixth port 64f and the ninth port 64i.

### [Fifth Mode]

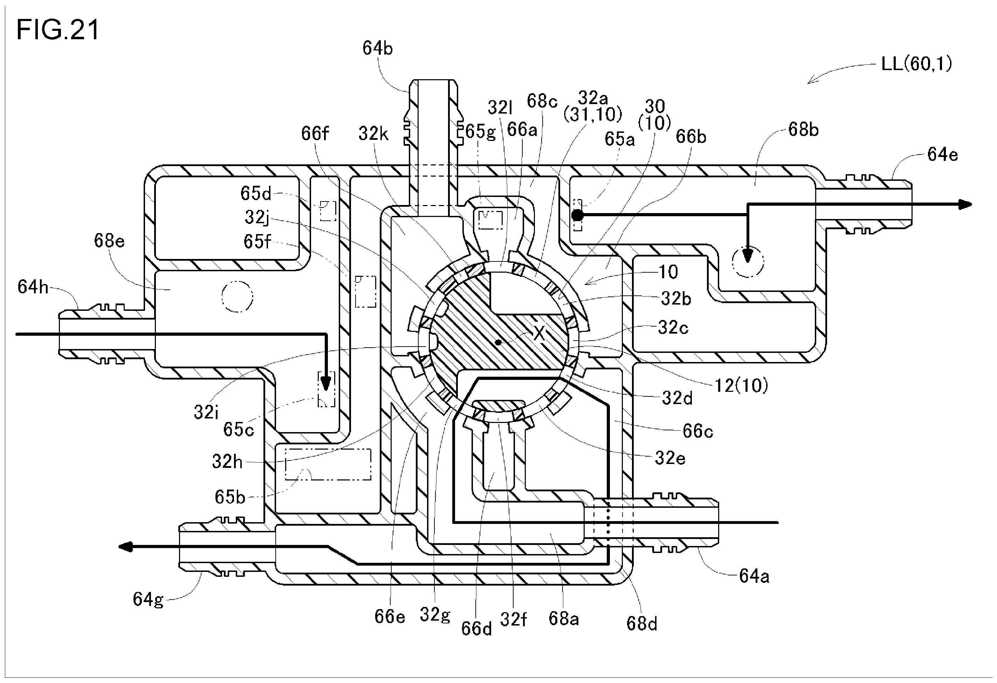

In the fifth mode, as illustrated in Figs. 21 to 24, the valve body 12 of the rotary valve 10 is rotated 90 degrees from the reference position in the counterclockwise direction, and the first water pump 40 is in operation and the second water pump 50 is stopped.

In the fifth mode, as illustrated in Figs. 21 to 24, cooling water having flowed into the lower layer LL from the first port 64a flows through the first lower-layer flow path 68a, the fifth lower-layer preliminary chamber 66e, the sixth lower-layer hole 36f, the seventh lower-layer sealing hole 32g, the second lower-layer opening 16b, the first lower-layer flow-through hole 14a, the first lower-layer opening 16a, the fourth lower-layer sealing hole 32d, the third lower-layer hole 36c, the third lower-layer preliminary chamber 66c, and the fourth lower-layer flow path 68d and flows out from the seventh port 64g. The cooling water having flowed out from the seventh port 64g flows through the not-illustrated pipe and cools or heats the not-illustrated auxiliary machine.

In addition, in the fifth mode, as illustrated in Figs. 21 to 24, cooling water having flowed into the lower layer LL from the eighth port 64h flows through the fifth lower-layer flow path 68e, the third communication hole 65c, the second upper-layer flow path 69b, the third upper-layer preliminary chamber 67c, the fifth upper-layer hole 37e, the sixth upper-layer sealing hole 33f, the first upper-layer opening 17a, the first upper-layer flow-through hole 15a, the fourth upper-layer opening 17d, the third upper-layer sealing hole 33c, the third upper-layer hole 37c, the first upper-layer preliminary chamber 67a, the first communication hole 65a, and the second lower-layer flow path 68b and flows out from the fifth port 64e, and also flows from the second lower-layer flow path 68b to the first water pump 40, where being pressurized, and flows out from the fourth port 64d. The cooling water having flowed out from the fourth port 64d and the fifth port 64e flows through the not-illustrated pipes and cools or heats the not-illustrated auxiliary machines.

In the fifth mode, cooling water does not flow through the second port 64b, the third port 64c, the sixth port 64f, and the ninth port 64i.

### [Sixth Mode]

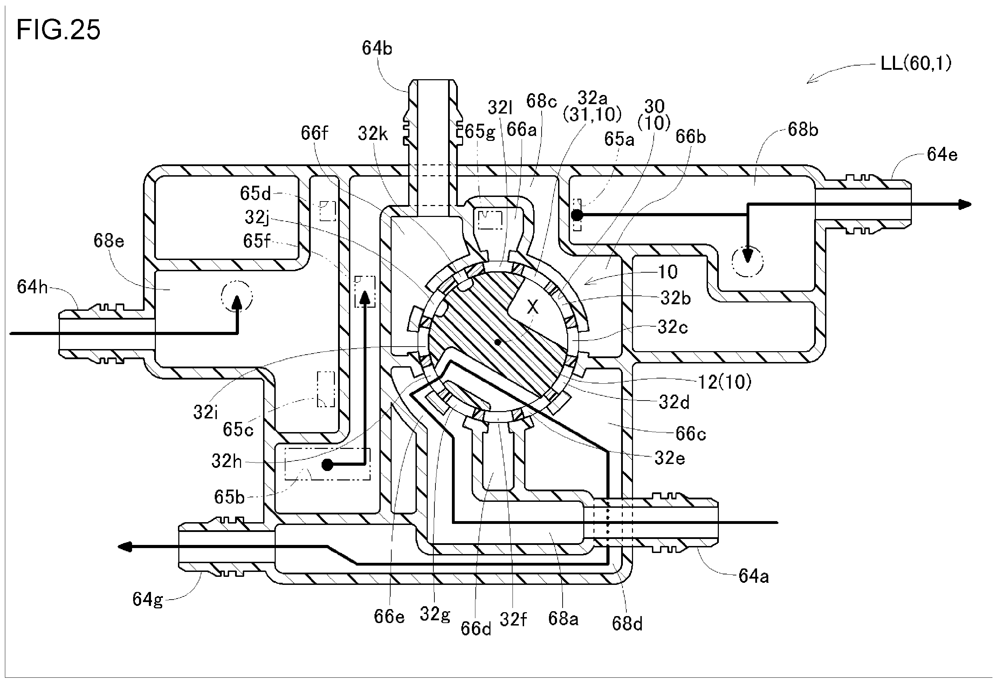

In the sixth mode, as illustrated in Figs. 25 to 28, the valve body 12 of the rotary valve 10 is rotated 60 degrees from the reference position in the counterclockwise direction, and the first water pump 40 and the second water pump 50 are in operation.

In the sixth mode, as illustrated in Figs. 25 to 28, cooling water having flowed into the lower layer LL from the first port 64a flows through the first lower-layer flow path 68a, the fifth lower-layer preliminary chamber 66e, the seventh lower-layer hole 36g, the eighth lower-layer sealing hole 32h, the second lower-layer opening 16b, the first lower-layer flow-through hole 14a, the first lower-layer opening 16a, the fifth lower-layer sealing hole 32e, the fourth lower-layer hole 36d, the third lower-layer preliminary chamber 66c, and the fourth lower-layer flow path 68d and flows out from the seventh port 64g. The cooling water having flowed out from the seventh port 64g flows through the not-illustrated pipe and cools or heats the not-illustrated auxiliary machine.

In addition, in the sixth mode, as illustrated in Figs. 25 to 28, cooling water having flowed into the fifth lower-layer flow path 68e in the lower layer LL from the eighth port 64h is pressurized in the second water pump 50 and flows out from the ninth port 64i. The cooling water having flowed out from the ninth port 64i flows through the not-illustrated pipe and cools or heats the not-illustrated auxiliary machine.

Further, in the sixth mode, as illustrated in Figs. 25 to 28, cooling water having flowed into the upper layer UL from the sixth port 64f flows through the first upper-layer flow path 69a, the second communication hole 65b, the third lower-layer flow path 68c, the fifth lower-layer flow path 68e, the sixth communication hole 65f, the fifth upper-layer preliminary chamber 67e, the seventh upper-layer hole 37g, the tenth upper-layer sealing hole 33j, the second upper-layer opening 17b, the first upper-layer flow-through hole 15a, the third upper-layer opening 17c, the first upper-layer sealing hole 33a, the first upper-layer hole 37a, the first upper-layer preliminary chamber 67a, the first communication hole 65a, and the second lower-layer flow path 68b and flows out from the fifth port 64e, and also flows from the second lower-layer flow path 68b to the first water pump 40, where being pressurized, and flows out from the fourth port 64d. The cooling water having flowed out from the fourth port 64d and the fifth port 64e flows through the not-illustrated pipes and cools or heats the not-illustrated auxiliary machines.

In the sixth mode, cooling water does not flow through the second port 64b and the third port 64c.

As described above, in the first to sixth modes in the regular mode, there exists a port through which cooling water does not flow among the first port 64a to the ninth port 64i. However, there are some cases where cooling water is required to flow through all the ports at the same time in, for example, air bleeding of a not-illustrated reserve tank or inspection before shipment.

Therefore, the cooling module 1 of the present embodiment has a full communication mode in which when cooling water is flowed in from one port, cooling water can be flowed out from all the other ports.

### [Operation in Full Communication Mode]

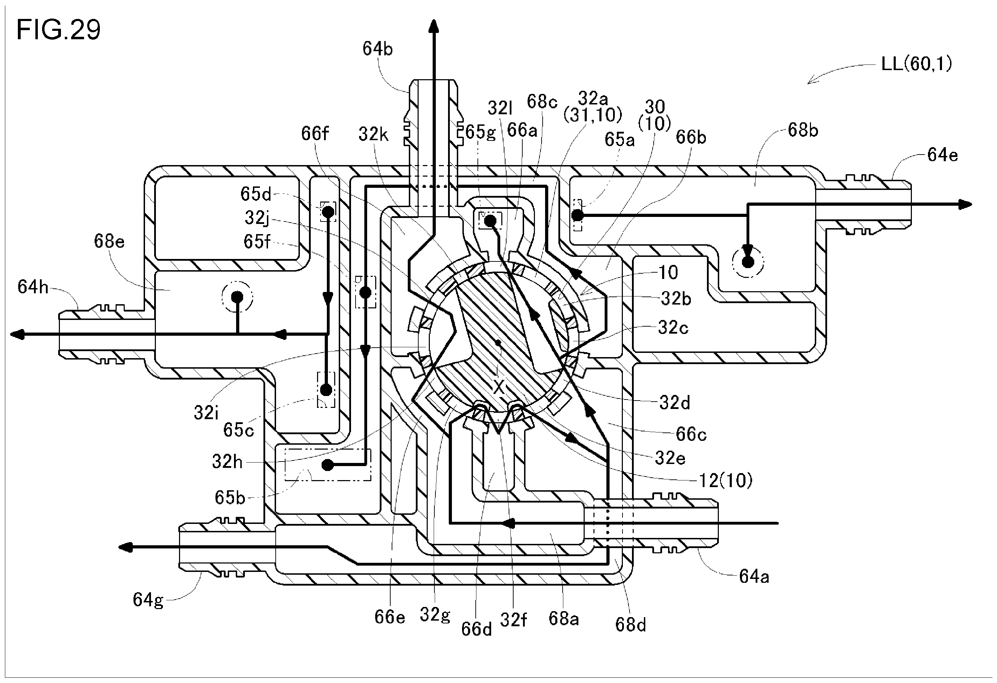

In the full communication mode, when cooling water is flowed in from the first port 64a, cooling water flows out from all of the second port 64b to the ninth port 64i. In the full communication mode, as illustrated in Figs. 29 to 32, the valve body 12 of the rotary valve 10 is rotated 165 degrees from the reference position in the clockwise direction, and the first water pump 40 and the second water pump 50 are in operation.

In the full communication mode, as illustrated in Figs. 29 to 32, cooling water having flowed into the lower layer LL from the first port 64a flows through the first lower-layer flow path 68a, the fifth lower-layer preliminary chamber 66e, the seventh lower-layer hole 36g, the eighth lower-layer sealing hole 32h, the fifth lower-layer opening 16e, the fourth lower-layer flow-through hole 14d, the fifth lower-layer opening 16e, the tenth lower-layer sealing hole 32j, the ninth lower-layer hole 36i, and the sixth lower-layer preliminary chamber 66f and flows out from the second port 64b.

In addition, as illustrated in Figs. 29 to 32, cooling water having flowed in from the first port 64a and reached the fifth lower-layer preliminary chamber 66e flows through the sixth lower-layer hole 36f, the seventh lower-layer sealing hole 32g, the fourth lower-layer opening 16d, the third lower-layer flow-through hole 14c, the fourth lower-layer opening 16d, the sixth lower-layer sealing hole 32f (and the fifth lower-layer hole 36e and the fourth lower-layer preliminary chamber 66d), the third lower-layer opening 16c, the second lower-layer flow-through hole 14b, the third lower-layer opening 16c, the fifth lower-layer sealing hole 32e, the fourth lower-layer hole 36d, the third lower-layer preliminary chamber 66c, and the fourth lower-layer flow path 68d and flows out from the seventh port 64g. Note that circumferential length of the fourth lower-layer opening 16d is longer than circumferential length of a wall body separating the sixth lower-layer sealing hole 32f and the seventh lower-layer sealing hole 32g from each other, and circumferential length of the third lower-layer opening 16c is longer than circumferential length of a wall body separating the fifth lower-layer sealing hole 32e and the sixth lower-layer sealing hole 32f from each other.

Further, as illustrated in Figs. 29 to 32, cooling water having flowed in from the first port 64a and reached the third lower-layer preliminary chamber 66c flows through the third lower-layer hole 36c, the fourth lower-layer sealing hole 32d, the second lower-layer opening 16b, the first lower-layer flow-through hole 14a, the second lower-layer opening 16b, the third lower-layer sealing hole 32c, the second lower-layer hole 36b, the second lower-layer preliminary chamber 66b, the third lower-layer flow path 68c, the second communication hole 65b, and the first upper-layer flow path 69a and flows out from the sixth port 64f. Note that circumferential length of the second lower-layer opening 16b is longer than circumferential length of a wall body separating the third lower-layer sealing hole 32c and the fourth lower-layer sealing hole 32d from each other.

Further, as illustrated in Figs. 29 to 32, cooling water having flowed in from the first port 64a and reached the third lower-layer flow path 68c flows through the sixth communication hole 65f, the fifth upper-layer preliminary chamber 67e, the seventh upper-layer hole 37g, the tenth upper-layer sealing hole 33j, the fifth upper-layer opening 17e, the second upper-layer flow-through hole 15b, the fifth upper-layer opening 17e, the ninth upper-layer sealing hole 33i (and the sixth upper-layer hole 37f and the fourth upper-layer preliminary chamber 67d), the third upper-layer opening 17c, the first upper-layer flow-through hole 15a, the first upper-layer opening 17a, the second upper-layer sealing hole 33b, the second upper-layer hole 37b, the first upper-layer preliminary chamber 67a, the first communication hole 65a, and the second lower-layer flow path 68b and flows out from the fifth port 64e, and also flows from the second lower-layer flow path 68b to the first water pump 40, where being pressurized, and flows out from the fourth port 64d. In addition, on this occasion, the cooling water also flows from the first upper-layer flow-through hole 15a through the second upper-layer opening 17b, the fifth upper-layer sealing hole 33e, the fourth upper-layer hole 37d, and the second upper-layer preliminary chamber 67b and flows out from the third port 64c. Note that circumferential length of the ninth upper-layer sealing hole 33i is longer than circumferential length of a wall body separating the third upper-layer opening 17c and the fifth upper-layer opening 17e from each other.

Further, as illustrated in Figs. 29 to 32, cooling water having flowed in from the first port 64a and reached the first lower-layer flow-through hole 14a flows through the first lower-layer opening 16a, the twelfth lower-layer sealing hole 32l, the first lower-layer hole 36a, the first lower-layer preliminary chamber 66a, the seventh communication hole 65g, the third upper-layer flow path 69c, the fourth communication hole 65d, and the fifth lower-layer flow path 68e and flows out from the eighth port 64h, and also flows from the fifth lower-layer flow path 68e to the second water pump 50, where being pressurized, and flows out from the ninth port 64i.

Further, as illustrated in Figs. 29 to 32, cooling water having flowed in from the first port 64a and reached the fifth lower-layer flow path 68e flows through the third communication hole 65c, the second upper-layer flow path 69b, the third upper-layer preliminary chamber 67c, the fifth upper-layer hole 37e, the sixth upper-layer sealing hole 33f, the second upper-layer opening 17b, the first upper-layer flow-through hole 15a, the second upper-layer opening 17b, the fifth upper-layer sealing hole 33e, the fourth upper-layer hole 37d, and the second upper-layer preliminary chamber 67b and flows out from the third port 64c. In addition, on this occasion, the cooling water also flows from the first upper-layer flow-through hole 15a through the first upper-layer opening 17a, the second upper-layer sealing hole 33b, the second upper-layer hole 37b, the first upper-layer preliminary chamber 67a, the first communication hole 65a, and the second lower-layer flow path 68b and flows out from the fifth port 64e, and also flows from the second lower-layer flow path 68b to the first water pump 40, where being pressurized, and flows out from the fourth port 64d. Note that circumferential length of the second upper-layer opening 17b is longer than circumferential length of a wall body separating the fifth upper-layer sealing hole 33e and the sixth upper-layer sealing hole 33f from each other.

As described above, the cooling module 1 of the present embodiment can be switched between the regular mode, which is a mode that is set when the motor of the electric vehicle is energized, such as while the electric vehicle is in the warm-up operation, is traveling, and is temporarily sopped, and the full communication mode, which is used for air bleeding of a reserve tank or inspection before shipment, by controlling the position of the valve body 12 of the rotary valve 10. Therefore, cooling water can be flowed through all the flow paths in the cooling module 1 without using a dedicated valve for air bleeding or controlling opening and closing of a plurality of valves.

### [Other Embodiments]

(1) Although in the above-described embodiment, the cooling module 1 includes the first water pump 40 and the second water pump 50, the number of water pumps may be one or three or more. In addition, the cooling module 1 does not have to include a water pump.
(2) Although in the above-described embodiment, the cooling module 1 includes nine ports, the number of ports may be eight or less or ten or more.
(3) Although in the above-described embodiment, the manifold 60 is formed by joining the first housing 61 and the second housing 62, the manifold 60 may be formed by joining three or more housings.

### [Summary of Above Embodiment]

Hereinafter, in the cooling module (1) described in the above-described embodiment, the following configurations are contemplated.
<1> One mode of embodiment of a cooling module (1) includes: a manifold (60) made of resin and including a plurality of housings (61, 62) joined to each other; and a rotary valve (10) formed by arranging a valve body (12) rotating about a rotation axis (X) in a cylindrical valve chamber (30) formed in the manifold (60), the manifold (60) includes a plurality of internal flow paths (65a, 65b, 65c, 65d, 65e, 65f, 65g, 68a, 68b, 68c, 68d, 68e, 69a, 69b, 69c) through which fluid flows and a plurality of ports (64a, 64b, 64c, 64d, 64e, 64f, 64g, 64h, 64i) that are connected to the plurality of internal flow paths (65a, 65b, 65c, 65d, 65e, 65f, 65g, 68a, 68b, 68c, 68d, 68e, 69a, 69b, 69c) and through which the fluid flows in or flows out, and the rotary valve (10) has a full communication mode in which when the fluid is flowed in from one port (64a) of the plurality of ports, the fluid can be flowed out from all the other ports (64b, 64c, 64d, 64e, 64f, 64g, 64h, 64i).
   According to the present mode of embodiment, since the rotary valve (10) has the full communication mode in which when fluid is flowed in from one port (64a) of the plurality of ports, the fluid can be flowed out from all the other ports (64b, 64c, 64d, 64e, 64f, 64g, 64h, 64i), cooling water can be flowed through all the flow paths in the cooling module (1) without using a dedicated valve for air bleeding or controlling opening and closing of the plurality of valves.
<2> In the cooling module (1) according to the above-described <1>, the rotary valve (10) includes a partition plate (12c) that partitions the valve chamber (30) in a direction perpendicular to the rotation axis (X) of the valve body (12), and a part of the valve body (12) on an upper side of the partition plate (12c) and the valve chamber (30) form a multi-directional valve and a part of the valve body (12) on a lower side of the partition plate (12c) and the valve chamber (30) also form a multi-directional valve.
   The present mode of embodiment is equivalent to a configuration in which one valve body (12) includes two multi-directional valves. Therefore, the full communication mode in which when the fluid is flowed in from one port (64a) of the plurality of ports, the fluid can be flowed out from all the other ports (64b, 64c, 64d, 64e, 64f, 64g, 64h, 64i) can be easily achieved with a minimum number of rotary valves (10).
<3> In the cooling module (1) according to the above-described <1> or <2>, the manifold (60) includes a plurality of preliminary chambers (66a, 66b, 66c, 66d, 66e, 66f, 67a, 67b, 67c, 67d, 67e) connected to the valve chamber (30) outside the valve chamber (30), each of the plurality of preliminary chamber (66a, 66b, 66c, 66d, 66e, 66f, 67a, 67b, 67c, 67d, 67e) is connected to at least one of the plurality of internal flow paths (65a, 65b, 65c, 65d, 65e, 65f, 65g, 68a, 68b, 68c, 68d, 68e, 69a, 69b, 69c), and the valve body (12) includes a flow-through hole (14a, 14b, 14c, 14d, 15a, 15b) connecting each pair of the preliminary chambers (66a, 66b, 66c, 66d, 66e, 66f, 67a, 67b, 67c, 67d, 67e) adjacent to each other in a circumferential direction of the valve chamber (30) in the full communication mode.
   According to the present mode of embodiment, since the valve body (12) includes a flow-through hole (14a, 14b, 14c, 14d, 15a, 15b) connecting each pair of the preliminary chambers (66a, 66b, 66c, 66d, 66e, 66f, 67a, 67b, 67c, 67d, 67e) adjacent to each other in the circumferential direction of the valve chamber (30) in the full communication mode, the full communication mode in which when the fluid is flowed in from one port (64a) of the plurality of ports, the fluid can be flowed out from all the other ports (64b, 64c, 64d, 64e, 64f, 64g, 64h, 64i) can be easily achieved with a minimum number of rotary valves (10).
<4> In the cooling module (1) according to the above-described <3>, the rotary valve (10) has a regular mode in which communication with at least one internal flow path (69c) of the plurality of internal flow paths (65a, 65b, 65c, 65d, 65e, 65f, 65g, 68a, 68b, 68c, 68d, 68e, 69a, 69b, 69c) is cut off, and in the regular mode, each of the flow-through holes (14c) is suitably opposed to one of the preliminary chambers (66a).

According to the present mode of embodiment, since in the regular mode, each of the flow-through holes (14c) is opposed to one of the preliminary chambers (66a), communication between each pair of the preliminary chambers (66a, 66b, 66c, 66d, 66e, 66f, 67a, 67b, 67c, 67d, 67e) adjacent to each other in the circumferential direction can be cut off and communication with at least one internal flow path (69c) can be cut off.

### [Industrial Applicability]

The present disclosure can be used for a cooling module.

## Claims

1. A cooling module (1) comprising:
a manifold (60) being made of resin and including a plurality of housings (61, 62) joined to each other; and
a rotary valve (10) formed by arranging a valve body (12) rotating about a rotation axis (X) in a cylindrical valve chamber (30) formed in the manifold (60), wherein
the manifold (60) includes a plurality of internal flow paths (65a, 65b, 65c, 65d, 65e, 65f, 65g, 68a, 68b, 68c, 68d, 68e, 69a, 69b, 69c) through which fluid flows and a plurality of ports (64a, 64b, 64c, 64d, 64e, 64f, 64g, 64h, 64i) that are connected to a plurality of the internal flow paths (65a, 65b, 65c, 65d, 65e, 65f, 65g, 68a, 68b, 68c, 68d, 68e, 69a, 69b, 69c) and through which the fluid flows in or flows out, and
the rotary valve (10) has a full communication mode in which, when the fluid is flowed in from one port (64a) of a plurality of the ports, the fluid can be flowed out from all the other ports (64b, 64c, 64d, 64e, 64f, 64g, 64h, 64i).

2. The cooling module (1) according to Claim 1, wherein the rotary valve (10) includes a partition plate (12c) that partitions the valve chamber (30) in a direction perpendicular to the rotation axis (X) of the valve body (12), and a part of the valve body (12) on an upper side of the partition plate (12c) and the valve chamber (30) form a multi-directional valve and a part of the valve body (12) on a lower side of the partition plate (12c) and the valve chamber (30) also form a multi-directional valve.

3. The cooling module (1) according to Claim 1 or 2, wherein
the manifold (60) includes a plurality of preliminary chambers (66a, 66b, 66c, 66d, 66e, 66f, 67a, 67b, 67c, 67d, 67e) connected to the valve chamber (30) outside the valve chamber (30),
each of a plurality of the preliminary chamber (66a, 66b, 66c, 66d, 66e, 66f, 67a, 67b, 67c, 67d, 67e) is connected to at least one of a plurality of the internal flow paths (65a, 65b, 65c, 65d, 65e, 65f, 65g, 68a, 68b, 68c, 68d, 68e, 69a, 69b, 69c), and
the valve body (12) includes a flow-through hole (14a, 14b, 14c, 14d, 15a, 15b) connecting each pair of the preliminary chambers (66a, 66b, 66c, 66d, 66e, 66f, 67a, 67b, 67c, 67d, 67e) adjacent to each other in a circumferential direction of the valve chamber (30) in the full communication mode.

4. The cooling module (1) according to Claim 3, wherein
the rotary valve (10) has a regular mode in which communication with at least one of the internal flow paths (69c) of a plurality of the internal flow paths (65a, 65b, 65c, 65d, 65e, 65f, 65g, 68a, 68b, 68c, 68d, 68e, 69a, 69b, 69c) is cut off, and,
in the regular mode, each of the flow-through holes (14c) is opposed to one of the preliminary chambers (66a).
